(19) Europäisches Patentamt
European Patent Office
Office européen des brevets

(11)  **EP 3 404 562 B1**

(12)  **EUROPÄISCHE PATENTSCHRIFT**

(45) Veröffentlichungstag und Bekanntmachung des Hinweises auf die Patenterteilung:
**01.11.2023  Patentblatt 2023/44**

(21) Anmeldenummer: **18020223.6**

(22) Anmeldetag: **22.05.2018**

(51) Internationale Patentklassifikation (IPC):
**F24F 12/00** (2006.01)

(52) Gemeinsame Patentklassifikation (CPC):
**G06F 30/00; G06F 30/20;** F28F 2200/00

(54) **RELATIONALES OPTIMIERUNGSVERFAHREN FÜR EINEN WÄRMEÜBERTRAGER EINER RAUMLUFTTECHNISCHEN ANLAGE**

RELATIONAL OPTIMISING PROCESS FOR A HEAT EXCHANGER OF AN AIR CONDITIONING SYSTEM

PROCÉDÉ D'OPTIMISATION RELATIONNELLE POUR UN ÉCHANGEUR THERMIQUE D'UNE INSTALLATION DE CONDITIONNEMENT D'AIR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **19.05.2017  DE 102017110912**

(43) Veröffentlichungstag der Anmeldung:
**21.11.2018  Patentblatt 2018/47**

(73) Patentinhaber: **Howatherm Klimatechnik GmbH 55767 Brücken (DE)**

(72) Erfinder: **Kaup, Christoph 55767 Brücken (DE)**

(74) Vertreter: **Kutsch, Bernd - trierpatent - Monaiser Strasse 21 54294 Trier (DE)**

(56) Entgegenhaltungen:
**EP-A1- 1 830 149      EP-A1- 1 975 858**
**CA-A- 1 153 361       CN-A- 102 508 958**
**CN-A- 104 657 551     DE-U1- 29 917 362**
**US-A1- 2007 179 917   US-A1- 2015 129 172**
**US-B2- 9 354 001**

- **Robert Brunner: "Wärmerückgewinn ung und Abwärmenutzung", , 1. Januar 1993 (1993-01-01), XP055508366, Gefunden im Internet: URL:https://www.energie.ch/bfk/ravel/355D. pdf [gefunden am 2018-09-20]**

- **H. Huber ET AL: "Luftkanal-Wärmetauscher", , 1. Januar 2000 (2000-01-01), XP055508362, Gefunden im Internet: URL:https://www.researchgate.net/profile/H einrich_Manz/publication/242685388_Luftkan al-Warmetauscher/links/5863c7da08ae329d620 3a1c6/Luftkanal-Waermetauscher.pdf [gefunden am 2018-09-20]**

- **Christoph Kaup,: "Wirtschaftliche Bewertung und Optimierung von Wärmerückgewinnungssystemen", , 1. Juni 2012 (2012-06-01), XP055508370, Gefunden im Internet: URL:https://www.google.com/url?sa=t&rct=j& q=&esrc=s&source=web&cd=1&cad=rja&uact=8 &v ed=2ahUKEwjjnYXkq8ndAhXKo4sKHcX_BrsQFj AAeg QICBAC&url=https%3A%2F%2Fwww.howather m.de% 2Fdownload%2F72_optimierungwrgsystemehlh 06 12_2&usg=AOvVaw0Hp2CuwkUJIMzzE4SQLtvr [gefunden am 2018-09-20]**

- **Christoph Kaup: "Chancen zur Steigerung der Energieeffizienz von zentralen RLT-Anlagen", , 1. Januar 2016 (2016-01-01), XP055508383, Gefunden im Internet: URL:http://ak-umwelt-im-krankenhaus.de/wor dpress/wp-content/uploads/2018/01/WS3_Kaup _Energieeffizienz_in_der_RLT.pdf [gefunden am 2018-09-20]**

- **Christoph Kaup: "Mehrdimensionale Wärmerückgewinnung in Europa", , 23. März 2018 (2018-03-23), XP055508396, Gefunden im Internet: URL:http://tga-kongress.de/wp-content/uplo ads/2018/04/05_Kaup_D.pdf [gefunden am 2018-09-20]**
- **Christoph Kaup: "Die mehrdimensionale Optimierung von Wärmerückgewinnungssytemen", , 30. September 2017 (2017-09-30), XP055508456, Gefunden im Internet: URL:https://www.google.com/url?sa=t&rct=j& q=&esrc=s&source=web&cd=2&cad=rja&uact=8 &v ed=2ahUKEwjjnYXkq8ndAhXKo4sKHcX_BrsQFj ABeg QIBRAC&url=https%3A%2F%2Fwww.howather m.de% 2Fdownload%2F88_mehrdimensional_optimiert e _wrg_im_kontext [gefunden am 2018-09-20]**

**Beschreibung**

Die Erfindung betrifft ein relationales Optimierungsverfahren für einen Wärmeübertrager einer raumlufttechnischen Anlage, insbesondere zur Wärmerückgewinnung, wie beispielsweise aus DE 10 2015 016 879 bekannt oder in Bd. 63 (2012) Nr. 6 - Juni der HLH Lüftung / Klima Heizung / Sanitär Gebäudetechnik, einem Organ der VDI-Gesellschaft Technische Gebäudeausrüstung, durch Herrn Professor Kaup, Fachhochschule Trier, unter dem Titel "Wirtschaftliche Bewertung und Optimierung von Wärmerückgewinnungssystemen" beschrieben.

Solche Wärmeübertrager haben beispielsweise im Abstand zueinander angeordnete, profilierte Lamellen zur gemeinsamen Verrippung mehrerer Rohre als Wärmeübertragerelemente. Solche Wärmeübertragerelemente sind bekanntermaßen dazu bestimmt, ein erstes Wärmeübertragerfluid (z. B. Luft) längs der Oberfläche der Lamellen und ein zweites Wärmeübertragerfluid (z. B. Wasser) in den Rohren zu führen. Die Basisgeometrien (Lamellenabstände, die vertikalen und horizontalen Rohrabstände, etc.) dieser Wärmeübertrager sind beispielsweise entsprechend der benötigten Wärmeleistung optimiert. Außer dieser spezifischen Optimierung des Wärmeübertragers bezogen auf seine Basisgeometrien besteht Bedarf, die äußeren Abmessungen (Höhe, Breite und Bautiefe) des Wärmeübertragers zu optimieren, um mit der raumlufttechnischen Anlage, in der der Wärmeübertrager einzusetzen ist, ein optimales Verhältnis zwischen Ertrag und Aufwand des Wärmeübertragers zu erhalten.

Ein relationales Optimierungsverfahren für einen Wärmeübertrager einer raumlufttechnischen Anlage ist zum Beispiel aus Dokument CN 102 508 958 A bekannt.

Generell wird die Güte eines Wärmerückgewinnungssystems (WRS) maßgeblich durch den Temperaturänderungsgrad, auch Rückwärmzahl ($\Phi$) genannt, bestimmt.

Der Temperaturübertragungsgrad gibt das Verhältnis der möglichen Temperaturänderung einer WRG-Einrichtung zur maximal möglichen Temperaturänderung, also dem Temperaturpotenzial zwischen Außen- und Fortluft, an. Er stellt somit einen thermischen "Übertragungsgrad" dar. Die maximal mögliche Leistung wird durch das Temperaturpotenzial, als die Temperaturdifferenz zwischen Abluft ($\vartheta_1$') und Außenluft ($\vartheta_2$'), gebildet. Damit ergibt sich ohne Änderung der Feuchte (trockener Betrieb) und der Zulufttemperatur ($\vartheta_2$") der Temperaturänderungsgrad mit:

$$\Phi_t = (\vartheta_2{''} - \vartheta_2{'}) / (\vartheta_1{'} - \vartheta_2{'}).$$

Neben dem Temperaturänderungsgrad wird die Effizienz der WRG auch durch die Druckverluste auf den Medienseiten bestimmt. Deshalb spielen die medienseitigen Widerstände der WRG eine große Rolle. Die Druckverluste der WRG bestimmen die Hilfsenergien, die zum Betrieb einer WRG zwingend notwendig sind. Diese Hilfsenergien werden im Wesentlichen durch die elektrischen Antriebe (wie Ventilatoren und weitere Verbraucher, z. B. Pumpen) bestimmt.

Um Wärmerückgewinnungssysteme im Einzelfall wirtschaftlich bewerten zu können, müssen die Erträge, welche durch die WRG erzielt werden, den Aufwendungen gegenübergestellt werden.

Dazu werden insbesondere die Hilfsenergien in Form von elektrischer Energie und weitere Kosten (auch Kapitalkosten) für den Betrieb der Systeme im Verhältnis zum erhaltenen Nutzen in Form von thermischen Energien bewertet.

Dabei kann mit Hilfe einer Jahressimulation die Effizienz der WRG im individuellen Projekt aussagekräftig betriebswirtschaftlich dargestellt und optimiert werden.

Letztlich kann eine Wirtschaftlichkeitsberechnung auf Jahrestemperaturverlaufswerten die entscheidenden Kennwerte liefern, die zur Beurteilung der Wirtschaftlichkeit der WRG in jedem Einzelfall herangezogen werden müssen.

Hier bietet es sich an, z. B. auf Basis der in DIN 4710 oder VDI 4710 vorliegenden meteorologischen Temperaturverteilung für den betreffenden Aufstellungsort der WRG die Jahresenergieberechnungen durchzuführen. In der DIN 4710 sind z. B. die Stundenverteilungen für mehrere deutsche Städte für 24 Stunden dargestellt.

In Abhängigkeit von der Außentemperatur in °C können die Häufigkeitswerte des Auftretens der Luftzustände je Stunde entnommen werden. Nun müssen in einem Jahresgang-Berechnungsverfahren für jeden Außenluftzustand die Zustände der WRG und der Sollwerte berechnet werden.

Wo liegt aber nun nach der Auslegung einer beliebigen WRG unter gegebenen projektspezifischen Rahmenbedingungen relational ein diskretes betriebswirtschaftliches Optimum für die Effizienz der WRG?

Dieses Problem wird durch ein computerimplementiertes relationales Optimierungsverfahren für einen Wärmeübertrager einer raumlufttechnischen Anlage nach Anspruch 1 gelöst.

Vorteilhafte Ausführungsformen sind Gegenstand von Unteransprüchen.

Die vorgeschlagene mehrdimensionale Optimierung von Wärmerückgewinnungssystemen im Kontext ökonomischer und ökologischer Zielsetzungen wird hierin offenbart.

Aus H. Huber at al., "Luftkanal-Wärmetauscher", September 2000, Hochschule Technik + Architektur Luzern, Schlussbericht Forschungsprogramm "Rationelle Energienutzung in Gebäuden" im Auftrag des Bundesamtes für Energie ist bekannt, Varianten eines Wärmeübertragers einer raumlufttechnischen Anlage mit unterschiedlichen Profilarten (Rundrohre, Rechteckprofile, mit und ohne Rippen, Anzahl der Rippen) des Wärmeübertragers hinsichtlich dessen Wärmeübertragungseigenschaften miteinander zu vergleichen., ohne Optimierung oder Variation von Höhe, Breite oder Länge der Wärmeübertragereinheit insgesamt.

**Bewertung der elektrischen Hilfsenergien**

Die Druckverluste der WRG bestimmen die Hilfsenergien, die zum Betrieb einer WRG zwingend notwendig sind. Diese Hilfsenergien werden im Wesentlichen durch die elektrischen Antriebe (wie Ventilatoren und weitere Verbraucher, z. B. Pumpen) bestimmt. Die erforderlichen elektrischen Leistungen errechnen sich dabei aus:

$$P_{el} = \dot{V} \bullet \Delta p_{WRG} \bullet 1 \, / \, \eta + P_{aux.}$$

mit:

$P_{el}$    Elektrische Leistung zum Betrieb der WRG [kW]
$V$    Volumenstrom bei Normdichte [m$^3$/s]
$\Delta p_{WRG}$    Differenzdruck der WRG [Pa]
$\eta$    Gesamtwirkungsgrad des Antriebs (z.B. Ventilatoren)
$P_{aux.}$    Weitere benötigte elektrische Hilfsleistung [kW]

Hierauf greift die aktuelle Fassung der DIN EN 13053 (Lüftung von Gebäuden - Zentrale raumlufttechnische Geräte-Leistungskenndaten für Geräte, Komponenten und Baueinheiten; Deutsche Fassung EN 13053:2012-02) zurück.

In der Verordnung EU 1253/2014 (Verordnung (EU) Nr. 1253/2014 der Kommission vom 7. Juli 2014 zur Durchführung der Richtlinie 2009/125/EG des Europäischen Parlaments und des Rates hinsichtlich der Anforderungen an die umweltgerechte Gestaltung von Lüftungsanlagen, veröffentlicht am 25.11.2014) fließt dagegen der elektrische Aufwand zur Bewertung der WRG in den SFP$_{int}$ Wert (specific fan power der Lüftungskomponenten) ein. Dieser Wert berechnet sich aus:

$$SFP_{int} = P_{el} \, / \, \dot{V} = \Delta p_{int} \, / \, \eta$$

mit:

$P_{el}$    Elektrische Leistung für die Lüftungskomponenten [kW]
$\Delta p_{int}$    Differenzdruck der Lüftungskomponenten (WRG, Filter, Gehäuse) [Pa]

**Beurteilung der Entwicklung der WRG unter ökonomischen Gesichtspunkten**

Die WRG hat sich in Deutschland sicherlich sehr positiv entwickelt. Sie zählt zu den wirtschaftlichsten Maßnahmen der Energieeffizienzsysteme. Daher erschien es in der Tat geboten, die WRG verpflichtend festzuschreiben. Diese Festlegung ist nun mit der EU-Verordnung EU 1253/2014 erfolgt.

Grundsätzlich ist die Einführung der Verordnung zu begrüßen. Dies zeigt auch die Entwicklung der Effizienzkriterien, die sich aus den begleitenden Studien ergeben hat. Wobei auch festgestellt werden muss, dass die Verordnung erst mit Gültigkeit der zweiten Stufe ab 2018 volkswirtschaftlich gesehen eine signifikante Verbesserung (min. 73 %) erwirken wird, da bereits seit 2011 in Deutschland ein mittlerer Temperaturübertragungsgrad von 68 % und damit dem Niveau der ersten Stufe entsprechend statistisch erreicht wurde (siehe Kaup, C., Studie zur Entwicklung des Energiebedarfs in RLT-Anlagen, UCB 2015).

Nichtsdestoweniger stellt sich immer häufiger die Frage, ob die generellen Mindestanforderungen auch in allen Einzelfällen sinnvoll sind und zu positiven Ergebnissen führen. Die Grundidee der Verordnung basiert auf dem grundsätzlichen, politischen Willen, Energie und $CO_2$ Emissionen einzusparen. Jedenfalls darf sie nicht dazu führen, dass es in den jeweiligen Einzelfällen zur Verschwendung von Energie kommen kann. Aus diesem Grund soll eine Verordnung nicht nur aus volkswirtschaftlicher Sicht, sondern auch aus betriebswirtschaftlichen Erwägungen eine optimale Wirtschaftlichkeit in jedem Einzelfall gewährleisten. Denn ein volkswirtschaftlich gutes Ergebnis führt nicht zwangsläufig in jedem Einzelfall zu einem betriebswirtschaftlichen Optimum. Jedoch ergibt die Summe der betriebswirtschaftlichen Optima in jedem Einzelfall zwingend ein volkswirtschaftliches Optimum.

## Das ökonomische Optimum der WRG auf Basis der Jahresenergiebetrachtung

Um Wärmerückgewinnungssysteme im Einzelfall wirtschaftlich bewerten zu können, müssen die Erträge, welche durch die WRG erzielt werden, den Aufwendungen gegenübergestellt werden. Dazu werden insbesondere die Hilfsenergien in Form von elektrischer Energie und weitere Kosten (auch Kapitalkosten) für den Betrieb der Systeme im Verhältnis zum erhaltenen Nutzen in Form von thermischen Energien bewertet.

Dabei kann neben den gesetzlichen Forderungen auch mit Hilfe einer Jahressimulation die Effizienz der WRG im individuellen Projekt aussagekräftig betriebswirtschaftlich dargestellt und optimiert werden.

Letztlich muss eine Wirtschaftlichkeitsberechnung auf Jahrestemperaturverlaufswerten die entscheidenden Kennwerte liefern, die zur Beurteilung der Wirtschaftlichkeit der WRG in jedem Einzelfall herangezogen werden müssen.

Es erscheint vorteilhaft, z. B. auf Basis der in DIN 4710 (Statistiken meteorologischer Daten zur Berechnung des Energiebedarfs von heiz- und raumlufttechnischen Anlagen in Deutschland: 2003-01) oder VDI 4710 (Blatt 1: Meteorologische Grundlagen für die Technische Gebäudeausrüstung, 2013-03) vorliegenden meteorologischen Temperaturverteilung für den betreffenden Aufstellungsort der WRG die Jahresenergieberechnungen durchzuführen. In der DIN 4710 sind z. B. die Stundenverteilungen für mehrere deutsche Städte für 24 Stunden dargestellt. Diese Figuren liefern auch die Daten für den Tagesbetrieb (6:00 bis 18:00 Uhr).

In Abhängigkeit von der Außentemperatur in °C können die Häufigkeitswerte des Auftretens der Luftzustände je Stunde entnommen werden. Nun werden in einem Jahresgang-Berechnungsverfahren für jeden Außenluftzustand die Zustände der WRG und der Sollwerte berechnet.

Nach der Auslegung einer beliebigen WRG wird erfindungsgemäß unter den gegebenen projektspezifischen Rahmenbedingungen relational ein diskretes betriebswirtschaftliches Optimum für die Effizienz gefunden. Diese Berechnung basiert auf einer eindimensionalen Optimierung bei welcher der Querschnitt der WRG als konstant angenommen wird und die Bautiefe der WRG als einzige Variable (Freiheitsgrad) zur Optimierung genutzt wird. Mit konstantem Querschnitt erfolgt die nachfolgend beschriebene Optimierungsrechnung mit konstanten Rynoldzahlen und somit mit konstantem Wärmedurchgangskoeffizienten (k-Zahl).

Dabei wird die ausgelegte WRG mit ihrer Rückwärmezahl (Φ) in eine korrespondierende dimensionslose Wärmeübertragerkennzahl NTU (Number of Transfer Units) umgewandelt. Diese Kennzahl wird definiert als:

$$NTU = (k \cdot A) / \dot{W}$$

Ebenfalls muss das Wärmestromkapazitätenverhältnis ($\mu$) aus Zu- und Abluft bestimmt werden:

$$\mu = \dot{W}_1 / \dot{W}_2$$

wobei:

k  Wärmedurchgangskoeffizient [$W / m^2 K$]
A  Wärmeübertragende Fläche [$m^2$]
W  Wärmekapazitätstrom mit $W = m \cdot c_{pL}$ [W / K]
m  Luftmassenstrom [kg / s]

Die Kennzahl NTU ist somit bei konstanter k-Zahl und konstantem Massenstrom der Luft (W) proportional zur Fläche der WRG und repräsentiert somit die Fläche, die sich bei konstanter Querschnittsfläche linear zu Bautiefe des Wärmeübertragers verhält.

Sie errechnet sich im Gegenstrom aus:

$$NTU = 1 / (1 - \mu) \cdot \ln ((1 - \mu \cdot \Phi) / (1 - \Phi))$$

bzw. bei $\mu = 1$ aus:

$$NTU = \Phi / (1 - \Phi)$$

Unter der Voraussetzung, dass sich Aufwendungen und Erträge der WRG entweder proportional zur Fläche (damit zum NTU) oder zur Rückwärmzahl (Φ) verhalten, wird durch diskrete Berechnung das Optimum der WRG gefunden.

Dabei wird aus den einzelnen NTU$_i$ des zu untersuchenden Bereichs der korrespondierende Temperaturübertragungsgrad ($\Phi_i$) bestimmt:

$$\Phi_i = (1 - e^{[(\mu - 1) \cdot NTU_i]}) / (1 - \mu \cdot e^{[(\mu - 1) \cdot NTU_i]})$$

bzw. bei $\mu = 1$ aus:

$$\Phi = NTU / (NTU + 1)$$

Zu den einzelnen Werten werden dann sowohl der jeweilige Aufwand als auch der Nutzen bestimmt. Dabei wird zwischen NTU- und $\Phi$-abhängigen Kosten und Erträgen unterschieden:

- Direkt NTU-abhängig

    o Kosten der WRG

        - - Kapitalkosten
        - - Wartungs- und Unterhaltungskosten
        - - Druckabfall der Wärmerückgewinnung

- Direkt $\Phi$-abhängig

    o Wärmeertrag (Nutzen)

        - - Wärme
        - - Kälte
        - - Mehrfachfunktionale Nutzung der WRG (z. B. Freie Kälte)

    o Minderinvestition der WRG

        - - Verringerung der Wärmeerzeugung und -verteilung
        - - Verringerung der Kälteerzeugung und -verteilung

Jeder Rückwärmzahl ($\Phi$) wird eindeutig sowohl der Aufwand als auch der Nutzen zugeordnet. Der Ertrag für jede Rückwärmzahl ergibt sich nun aus der

Differenz zwischen dem Nutzen und dem entsprechenden Aufwand. Der höchste Ertrag bestimmt dann das eindimensionale Optimum der WRG. Damit liegt fest, welcher Temperaturübertragungsgrad der optimale unter den gegebenen Bedingungen ist. Unter den gegebenen Rahmenbedingungen würde somit eine WRG mit geringerer, aber auch mit höherer Rückwärmzahl einen geringeren Ertrag erwirtschaften (siehe Wirtschaftliche Bewertung und Optimierung von Wärmerückgewinnungssystemen, Springer-VDI Verlag, HLH 06/2012)

**Wirtschaftlichkeitsberechnungen am Beispiel**

im Folgenden werden am Beispiel Wirtschaftlichkeitsberechnungen nach den beschriebenen Verfahren dargestellt. Anhand weniger charakteristischer Daten kann die Berechnung im Einzelfall erfolgen.

Neben den WRG-Funktionen, den Sollwerten im Heiz- und Kühlbetrieb, den spezifischen Energiekosten etc. muss das Lastprofil der WRG und deren Standort definiert werden. Diese Faktoren bilden den Rahmen zur jeweiligen Optimierung im Einzelfall. Aus diesem Lastprofil (Nutzung) errechnen sich die Laufzeiten der WRG.

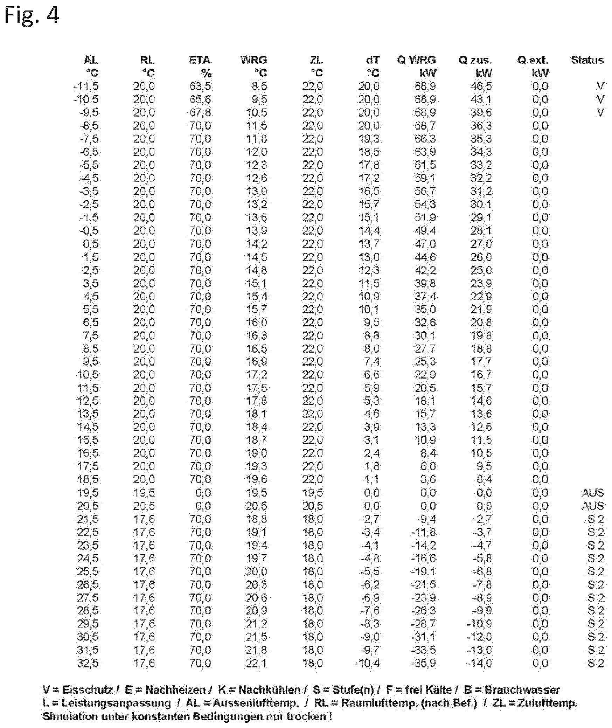

Figur 4: Funktion der WRG (Fall 1)

Auf der ersten Ergebnisseite (Figur 4) wird die Funktion der WRG in Abhängigkeit von der Außenlufttemperatur dargestellt, die sich aus dem Temperaturübertragungsgrad und den Zuständen der WRG (z. B. Vereisungsschutz oder mehrstufige Verdunstungskühlung) ergibt.

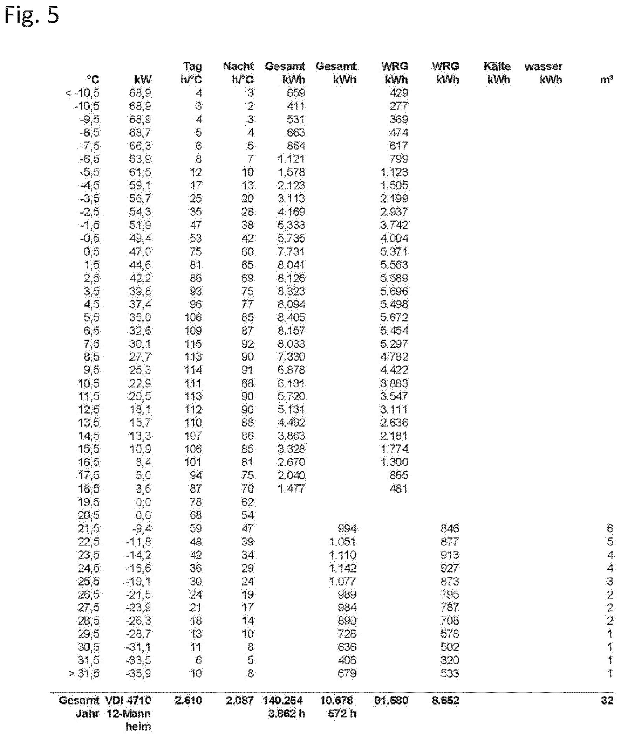

Figur 5: Energien der WRG

in Figur 5 werden tabellarisch die einzelnen thermischen Arbeiten dargestellt, die sich aus der Multiplikation der Leistungen mit ihrer Häufigkeit ergeben. Auch der Wasserverbrauch einer indirekten Verdunstungskühlung wird aufgezeigt.

Man erkennt auch, dass die WRG im Beispiel in 3.862 h (82,2 % der Gesamtnutzungszeit) zur Deckung des Wärmebedarfs und zu 572 h (12,2 % der Gesamtnutzungszeit im Beispiel 4.697 h/a) zur Kühlung genutzt wird.

Figur 6: Zusammenfassung der Wirtschaftlichkeitsberechnung

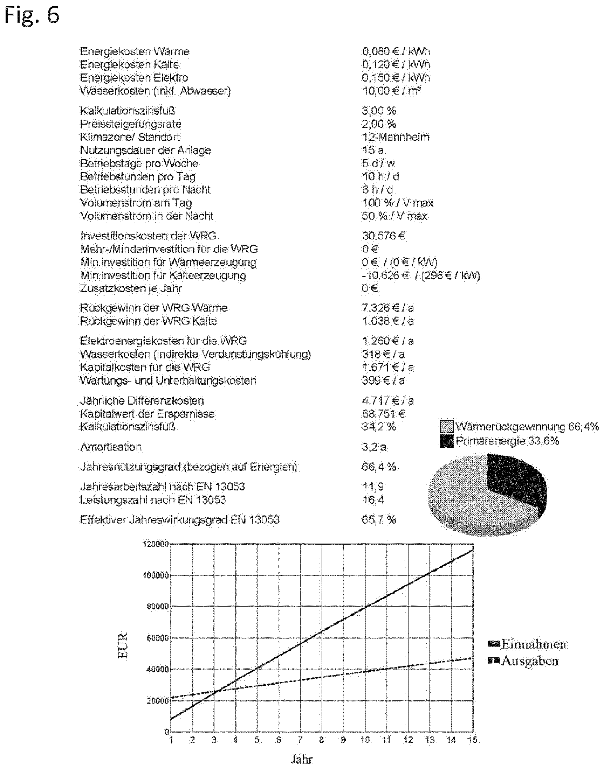

in Figur 6 sind die Ergebnisse der Wirtschaftlichkeitsberechnung übersichtlich zusammengefasst. Neben den Rahmenbedingungen wie Laufzeiten, Energiepreise, Zinssätze etc. wird der Kapitalwert der Ersparnisse, in diesem Fall nach 15 Jahren Nutzungsdauer, kalkuliert und die Amortisation als Schnittpunkt der beiden Linien (abgezinste Einnahmen und Ausgaben) dargestellt.

Die Amortisation liegt in diesem Fall bei 3,2 Jahren. Der Kapitalwert der Ersparnisse liegt bei etwa 68.750 Euro. Ebenfalls sind die Kennzahlen auf Basis des Jahresenergievergleiches (z. B. Jahresarbeitszahl der WRG mit 11,9) aufgeführt.

Heute wird jedoch immer häufiger die Frage gestellt, mit welchem, "optimalen" Übertragungsgrad der höchste Ertrag erzielt werden kann? Diese Frage beantwortet die Optimierung der WRG, die im Beispiel eindimensional durch die Variierung der Bautiefe und damit bei konstantem Strömungsquerschnitt der Fläche oder NTU der WRG dargestellt ist.

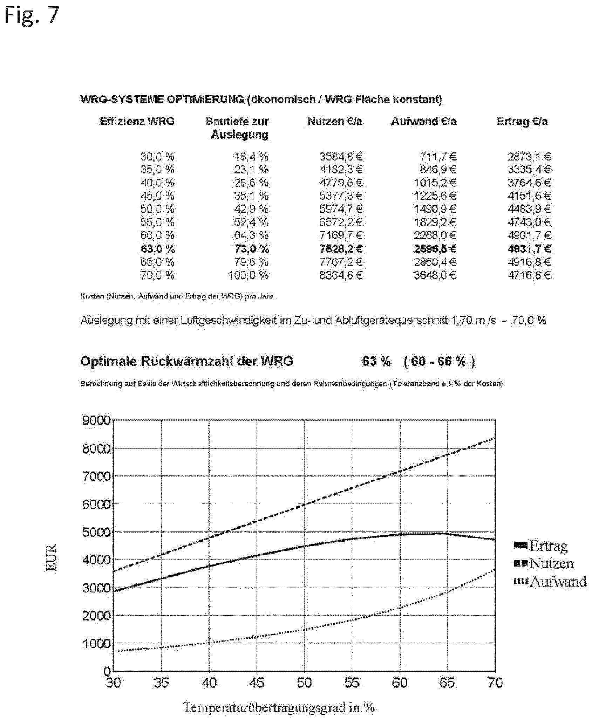

Figur 7: Optimum der Wärmerückgewinnung

Figur 7 zeigt die Ermittlung des eindimensionalen, relationalen Optimums der WRG bei Veränderung der Bautiefe der WRG. Jedem Temperaturübertragungsgrad zwischen 30 % und 85 % wird der erforderliche Aufwand und der mögliche Nutzen der WRG gegenübergestellt. Der Differenzbetrag stellt den Ertrag pro Jahr dar. Der höchste Ertrag mit 4.932 €/a wird im Beispiel mit einem Temperaturübertragungsgrad von 63 % erreicht.

Da die Ertragskurve im Bereich des Optimums relativ flach verläuft, kann bei Akzeptanz eines Toleranzbereichs von +- 1 % der Kosten ein optimaler Bereich des Temperaturübertragungsgrades in diesem Fall von 60 bis 66 % bestimmt werden.

Mit diesem Optimum wäre die erste Stufe der Ökodesignverordnung (min. 63 %, für Kreislaufverbundsysteme) erfüllt. Die zweite Stufe mit (min. 68 %) würde betriebswirtschaftlich zu einer WRG führen, die pro Jahr einen etwa 200 Euro geringeren Ertrag erwirtschaftet, als dies im ökonomischen Optimum bei konstanter Anströmfläche der Fall wäre. Diese Optimierung gilt selbstverständlich nur für die festgelegten Rahmenbedingungen und den gewählten Querschnitt, der im Beispiel zu einer Luftgeschwindigkeit von 1,7 m/s führt. Demzufolge läge im Beispiel die optimale Bautiefe bei 73 % der ursprünglichen Auslegung mit einem Übertragungsgrad von 70 %.

Ändern sich z. B. die Laufzeit der WRG oder die Energiekosten, verschiebt sich auch das Optimum der WRG deutlich.

Neben der Optimierung auf monetärer Basis besteht selbstverständlich auch die Möglichkeit eine Optimierung auf der Basis von $CO_2$ Emissionen durchzuführen.

Dabei werden sowohl die Aufwände, als auch der Nutzen der WRG analog zur beschriebenen monetären Berechnung in $CO_2$ Äquivalenten bewertet.

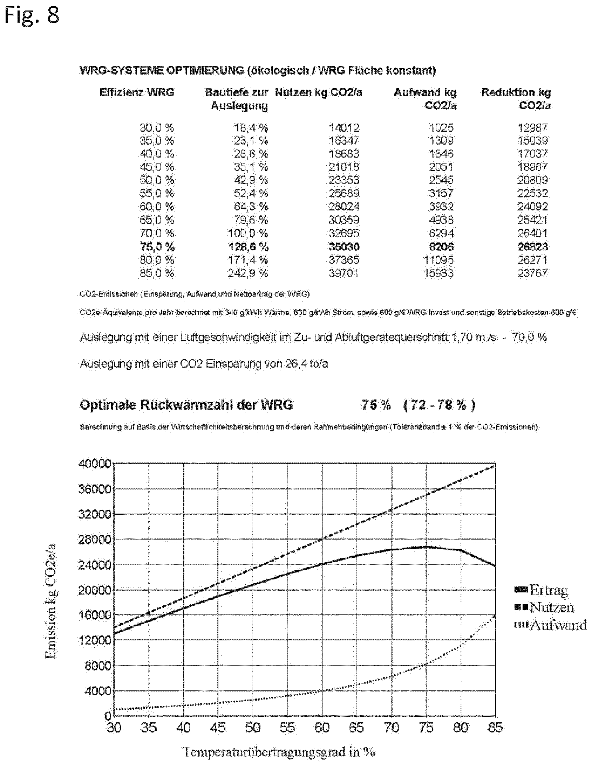

Figur 8 zeigt die Ermittlung des eindimensionalen und ebenfalls relational berechneten Optimums der WRG auf der Basis von $CO_2$ Äquivalenten. Dabei wird dem Nutzen der WRG der Aufwand in $CO_2$ Äquivalenten gegenübergestellt.

im Beispiel wurde für die Wärmeerzeugung $CO_2$ Äquivalente von 340 g e$CO_2$/kWh (Öl) und für den elektrischen Aufwand (Strommix) von 630 g e$CO_2$/kWh ausgewählt. Des Weiteren müssen aber auch die zusätzlichen Aufwände zur Herstellung der WRG, zur Wartung, etc. in $CO_2$ Äquivalenten berücksichtigt werden. Hierzu wird als "sekundärer $CO_2$ Fußabdruck" sowohl für die Herstellung der WRG, als auch für die sonstigen Betriebskosten ein Mittelwert von 600 e$CO_2$/kWh gewählt (siehe Interseroh und Fraunhofer UMSICHT, sowie VDI-Wärmeatlas, Berechnungsblätter für den Wärmeübergang, 7. Auflage, Mb 3)

Aus dieser Optimierung ist zu erkennen, dass sich nun das Optimum sehr deutlich von 63 % (monetäre Bewertung) auf nun 75 % verschiebt.

Im Beispiel wird also bei einer Rückwärmzahl von 75 % das größte Potenzial an $CO_2$ (hier 26.823 kg/a) zurückgewonnen.

Auch macht dieses Beispiel deutlich, dass die Basis einer Optimierungsrechnung einen wesentlichen Einfluss auf das Ergebnis hat. Liegt der Betrachtungsfokus einer WRG auf der möglichen $CO_2$ Einsparung, wäre eine WRG mit einem deutlich höheren Temperaturübertragungsgrad (0,75) sinnvoll, während aus rein monetärer Sicht eine "kleinere" WRG mit niedrigerem Übertragungsgrad (0,63) optimal wäre.

Figur 8: Optimum der Wärmerückgewinnung auf Basis von $CO_2$ Äquivalenten

Würde beispielsweise die WRG nach dem monetären Optimum ausgewählt, wäre zwar der ökonomische höchste Ertrag erreicht, aber es würden aber "nur" rund 25 to. $CO_2$ Emissionen pro Jahr vermieden werden, statt des optimalen Werts von rund 26,8 to./a. Umgekehrt würde bei der Wahl des ökologisch optimalen Systems mit 75 % zwar 26,8 to. $CO_2$/a vermieden werden, aber monetär läge der Ertrag bei nur noch bei rund 4.500 €/a gegenüber dem monetären Optimum von rund 4.900 €/a. Die eindimensionale Optimierung (sowohl monetär als auch ökologisch) setzt allerdings voraus, dass der Anströmquerschnitt, also Höhe und Breite der WRG konstant groß sind. Wird nicht die Bautiefe der WRG, sondern ihre Anströmfläche in der Optimierungsrechnung variiert, wird die Optimierung der WRG deutlich komplexer, da sich auch die Wärmeübertragung und die spezifischen Druckverluste der WRG mit der geänderten Geschwindigkeit signifikant ändert.

## Änderung der Wärmeübertragung bei Anpassung des Querschnitts der WRG

Mit der Änderung des Anströmquerschnitts wird die k-Zahl (Wärmedurchgangskoeffizient) der WRG nicht mehr als konstant angenommen. Sie ändert sich mit der Änderung der Strömungsgeschwindigkeit deutlich.
Der Wärmedurchgangskoeffizient (k) ist der reziproke Wert des Wärmewiderstandes (R), der sich errechnet mit:

$$R = 1 / k = 1 / ( 1 / \alpha_i + d / \lambda + 1 / \alpha_a )$$

 wobei:

$\alpha_i$     Wärmeübergangskoeffizient innen (z. B. Wasser) in $W/m^2/K$
d     Dicke des wärmeleitenden Materials (z. B. des Rohres) in m
$\lambda$     Wärmeleitkoeffizient in W/m/K
$\alpha_a$     Wärmeübergangskoeffizient außen (z. B. Luft) in $W/m^2/K$

Die Wärmeübertragung durch eine erzwungene Strömung ergibt sich aus folgender Beziehung:

$$\alpha = \dot{q} / (\vartheta_M - \vartheta_W) = Nu \cdot \lambda / l$$

wobei:

q     Wärmestrom in W/s
Nu     dimensionsloser Wärmeübergangskoeffizient, Nusseltzahl mit: $Nu = f ( Pr, Re)$
$\lambda$     Wärmeleitkoeffizient des strömenden Mediums in W/m/K
l     charakteristische Länge der Lamelle in m
$\vartheta$     Temperatur des Mediums (M) abzüglich der Wand-Temperatur (W) (z. B. Lamelle)

## Wärmeübertragung auf der Luftseite

Die dimensionslose Nusseltzahl (Nu) errechnet sich an der berippten Oberfläche (Lamelle) eines Wärmeübertragers mit versetzter Rohranordnung ab vier Rohrreihen auf der Luftseite[1] aus:

$$Nu = 0{,}38 \cdot Re^{0,6} \cdot (A/A_0)^{-0,15} \cdot Pr^{1/3}$$

für turbulente Strömung mit $10^3 < Re < 10^5$ und $5 < A/A_0 < 30$
wobei:

Pr     Prandtl-Zahl (stoffabhängige Größe des Mediums, z. B. Luft)

$$Pr = \rho \cdot \upsilon \cdot c_p / \lambda$$

mit:

$\rho$     Luftdichte in kg/m$^3$
$\upsilon$     kinematische Viskosität in m$^2$/s
$c_p$     spezifische Wärmekapazität in kJ/kg/K
$\lambda$     Wärmeleitfähigkeit in W/m/K
Re     Reynold-Zahl (strömungsabhängige Größe) mit

$$Re = w \cdot l / \upsilon$$

mit:

w     Strömungsgeschwindigkeit im engsten Querschnitt in m/s
l     charakteristische Länge der Lamelle in m

$$l = \pi / 2 \cdot \sqrt{(d^2 + h^2)}$$

$A/A_0$ Oberflächenverhältnis äußere Fläche A zur Rohrfläche innen $A_0$

$$A/A_0 = 1 + 2 \cdot h \cdot (h + d + s) / t_r / d$$

wobei:

h charakteristische Lamellenhöhe

$$h = (4 \cdot s_1 \cdot s_2 / (2 \cdot s_1 + 2 \cdot s_2) - d) / 2$$

mit:

$s_1$     Achsabstand der Rohre in Luftrichtung in m
$s_2$     Achsabstand der Rohre quer zur Luftrichtung in m
d     Rohrdurchmesser in m
s     Materialdicke der Lamelle in m
$t_r$     Lamellenteilung in m

**Wärmeübertragung innerhalb des Rohres**

Die dimensionslose Nusseltzahl (Nu) errechnet sich hier innerhalb der Rohre (Medienseite), (siehe VDI-Wärmeatlas, Berechnungsblätter für den Wärmeübergang, 7. Auflage, Gb 7) aus:

$$Nu_{turb} = \xi/8 \cdot (Re-1000) \cdot Pr / [1 + 12.7 \cdot \sqrt{(\xi/8)} \cdot (Pr^{2/3}-1)] \cdot \{1 + (d_i/l)^{2/3}\}$$

für turbulente Strömung mit $2.300 < Re < 10^5$ und $0,6 < Pr < 2000$ wobei:

$\xi$     Widerstandsbeiwert des Rohres mit: $\xi = [1.82 \cdot \log(Re) - 1,64]^{-2}$

mit:

$$Re = w \cdot d_i / \upsilon$$

mit:

$d_i$  Innendurchmesser des Rohres in m

$I$  Rohrlänge in m

Aus der dimensionslosen Nusseltzahl (Nu) ergibt sich der Wärmeübergangskoeffizient ($\alpha$) mit:

$$\alpha = Nu \cdot \lambda / d$$

**Näherungsgleichung zur Umrechnung des Wärmedurchgangskoeffizienten**

Das vorab beschriebene Verfahren ist relativ komplex und aufwändig. Zur Berechnung einer Vielzahl von Optimierungsrechnungen auf Basis von Einzelauslegungen wird das Verfahren daher als sein wesentliches Entwicklungsergebnis brauchbar vereinfacht. Insbesondere bei veränderten Bedingungen, also bei veränderlichen Luft- oder Medienmengen, müssen für sämtliche Zustände die Wärmedurchgangskoeffizienten explizit berechnet werden. Häufig wird in der Praxis vereinfacht mit einer konstanten k-Zahl gerechnet, was dann zu erheblichen Fehlern führt und daher für eine Optimierungsrechnung eher ungeeignet ist.

Das im folgenden beschriebene Verfahren ist ein relatives Näherungsverfahren, mit dem ein ausgelegter und validierter Wärmedurchgangskoeffizient (k) leicht auf unterschiedliche Betriebsbedingungen umgerechnet werden kann.

Dazu wird die ursprüngliche k-Zahl, die sich aus der Auslegung oder Messung ergibt, aufgrund der sich ändernden Luft- und Mediengeschwindigkeiten mit folgender Gleichung korrigiert:

$$k_{korr} = k_{org} \bullet (w_{L\ korr} / w_{L\ org})^{0,4} \bullet (w_{W\ korr} / w_{W\ org})^{0,4}$$

mit:

$k_{korr}$  umzurechnende k-Zahl in W/m$^2$/K
$k_{org}$  ursprüngliche k-Zahl gemessen oder berechnet in W/m$^2$/K
$w_{L\ korr}$  Luftgeschwindigkeit im umzurechnenden Betriebszustand in m/s
$w_{L\ org}$  ursprüngliche Luftgeschwindigkeit in m/s
$w_{M\ korr}$  Mediengeschwindigkeit im umzurechnenden Betriebszustand in m/s
$w_{M\ org}$  ursprüngliche Mediengeschwindigkeit im Rohr in m/s

Aufgrund umfangreicher Vergleichsberechnungen kann die Gleichung im Bereich von:

$$1,6 < w_{L\ korr} / w_{L\ org} < 0,4$$

und:

$$1,4 < w_{M\ korr} / w_{M\ org} < 0,8$$

verwendet werden. Sie leitet sich der obigen Näherungsgleichung zur Umrechnung von Temperaturänderungsgraden von Wärmerückgewinnungssystemen ab.

Die Abweichungen zur Berechnung nach VDI-Wärmeatlas liegen innerhalb der o. g. Gültigkeitsgrenzen im Bereich von etwa $\pm$ 3 % und damit auf einem niedrigen Niveau.

Bei Luft-/Luftwärmeübertragern kann analog folgende Gleichung verwendet werden

$$k_{korr} = k_{org} \bullet (w_{1\ korr} / w_{1\ org})^{0,4} \bullet (w_{2\ korr} / w_{2\ org})^{0,4}$$

mit:

$k_{korr}$  umzurechnende k-Zahl in W/m$^2$/K
$k_{org}$  ursprüngliche k-Zahl gemessen oder berechnet in W/m$^2$/K
$w_{1\ korr}$  Luftgeschwindigkeit des Abluftstromes im Betriebszustand in m/s
$w_{1\ org}$  ursprüngliche, ausgelegte Luftgeschwindigkeit der Abluft in m/s

$w_{2\,korr}$    Luftgeschwindigkeit der Zuluft im Betriebszustand in m/s

$w_{2\,org}$    ursprüngliche, ausgelegte Luftgeschwindigkeit der Zuluft in m/s

In einer vorteilhaften Ausführungsform ist eine Näherungsgleichung wie folgt aufgebaut:

$$k_{korr} = k_{org} \cdot (1 + w_{L\,korr} / w_{L\,org}) / 2 \cdot (1 + w_{W\,korr} / w_{W\,org}) / 2$$

bzw.

$$k_{korr} = k_{org} \cdot (1 + w_{1\,korr} / w_{1\,org}) / 2 \cdot (1 + w_{2\,korr} / w_{2\,org}) / 2$$

### Überprüfung der Näherungsgleichung im Versuch

Zur Prüfung der beschriebenen Näherungsgleichung insbesondere bei niedrigen Geschwindigkeiten, wurde eine Messung im Labor sowohl an einem Doppelplattenwärmeübertrager im Kreuz-Gegenstrom als auch bei berippten Wärmeübertragern im Gegenstrom durchgeführt.

Durch die Messung wird deutlich, dass die Näherungsgleichung bis zu einer Luftgeschwindigkeit von 0,6 m/s sehr gute Ergebnisse im Vergleich zur Messung liefert. Der Fehler der Näherungsgleichung im Vergleich zur Messung lag bei unter 1 %.

Es war bei der Messung allerdings zu beobachten, dass der Wärmeübergang bei Luftgeschwindigkeiten von 0,25 m/s kaum noch stabil im Beharrungszustand gehalten werden konnte. Auch die Wärmebilanz beider Massenströme lag 9 % auseinander und damit über der maximal zulässigen Abweichung von 5 % der EN 308.

### Änderung des Druckabfalls der Wärmerückgewinnung

Parallel zur Änderung der Wärmeübertragung muss der sich ergebenden Druckabfall bei geänderter Fläche bestimmt werden. Theoretisch ändert sich der Druckabfall $\Delta P$ eines Körpers sich nach der Beziehung:

$$\Delta P = \xi \cdot \tfrac{1}{2} \cdot \rho \cdot w^2$$

mit:

$\xi$    Widerstandsbeiwert eines Körpers (hier WÜ)

$\rho$    Dichte des Mediums (hier Luft mit 1,2 kg/m$^3$)

w    Strömungsgeschwindigkeit des Mediums

Aufgrund von zahlreichen Messungen an ausgeführten WRG-Einrichtungen hat sich jedoch gezeigt, dass sich der Druckverlust nicht quadratisch ändert, sondern mit einem Exponenten in einem Bereich von 1,5 bis 1,7.

### Das zweidimensionale Optimum der Wärmerückgewinnung

Wird beispielsweise die Bautiefe der WRG konstant belassen und als Freiheitsgrad der Berechnung der Querschnitt der WRG verändert, ergibt sich ein völlig anderes, zweidimensionales Optimum, da bei sehr niedrigen Querschnitten und den damit verbundenen sehr hohen Strömungsgeschwindigkeiten die Druckverluste und somit der elektrische Aufwand der WRG mit dem Exponent 2,6 bezogen auf die Luftgeschwindigkeit steigt.

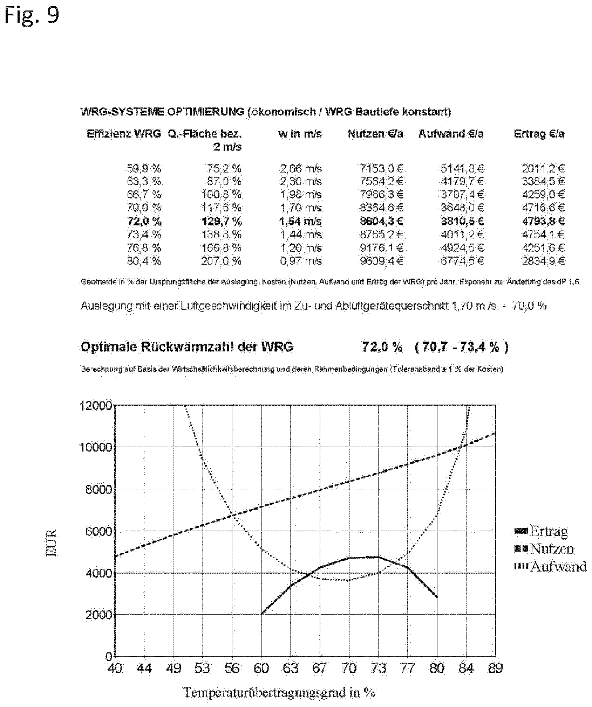

Figur 9: Das zweidimensionale Optimum der WRG

Bei sehr großen Querschnitten sinkt der Druckabfall, aber die Kosten der WRG steigen nahezu quadratisch zum Querschnitt.

Auf Basis der zweidimensionalen Optimierung verschiebt sich das monetäre Optimum im Beispiel auf 72 %. Der höchste Ertrag mit 4.794 € wird bei einem Querschnitt von rund 130 % (bez. auf 2 m/s), also bei 1,54 m/s erreicht.

Zu erkennen ist, dass bei einer Optimierung unter Veränderung der Querschnittsänderung das Optimum deutlich schärfer zum Tragen kommt.

Allerdings liegt in diesem Beispiel der maximale Ertrag mit rund 4.790 €/a um rund 200 € niedriger, als der Ertrag, der durch die eindimensionale Optimierung erreicht wurde. Dies muss aber nicht immer so sein, da sowohl das eindimensionale, als auch das zweidimensionale Optimum völlig unabhängig voneinander ergeben und von der ursprünglichen Auslegungsgeschwindigkeit abhängig sind.

**Das mehrdimensionale Optimum der Wärmerückgewinnung**

Die Entwicklung nimmt ferner an, dass es für eine tatsächliche und wahrhafte Optimierung der WRG vorteilhaft ist, wenn sämtliche Geometrien, also alle drei Dimensionen geändert werden können.

Sowohl der Querschnitt (Höhe und Breite der WRG), als auch die Bautiefe müssen in die Optimierung einfließen und dienen daher als Variablen zur Berechnung des maximalen Ertrags.

In einem Algorithmus werden daher sowohl der Querschnitt, als auch in einer zweiten Berechnungsschleife die Bautiefe der WRG durch Iteration nach den beschriebenen Verfahren bestimmt.

Hierzu wird in einer ersten Berechnungsschleife die Fläche des WÜ der WRG von einem minimalen Startwert SW1 bis zu einem maximal zu wählenden Endwert EW1 in einer Schrittweite SWE1 durchgeführt. Für jeden Einzelwert werden auf Basis der ursprünglichen k-Zahl der Auslegung die sich nun ergebenen relationalen k-Zahlen und spezifische Druckverluste für die jeweiligen Flächen bestimmt.

Mit diesen sich ergebenden k-Zahlen werden nun in einer zweiten Schleife die Bautiefe des WÜ der WRG von einem zweiten Startwert SW2 bis zu einem maximal zu wählenden Endwert EW2 in einer Schrittweite SWE2 geändert.

Die relationale k-Zahl aus der Iterationsschleife 1 bleibt in der zweiten Iterationsschleife konstant.

In dieser zweiten Schleife wird auf Basis der bereits beschriebenen eindimensionalen Optimierung der jeweilige maximale Ertrag aus der Differenz zwischen Nutzen und Aufwand bestimmt.

So ergeben sich für jede Fläche im Bereich des Startwerts SW2 bis zum maximalen Endwert EW2 das jeweilige Optimum, das sich durch den maximalen Ertrag für jede zu berechnende Fläche auszeichnet.

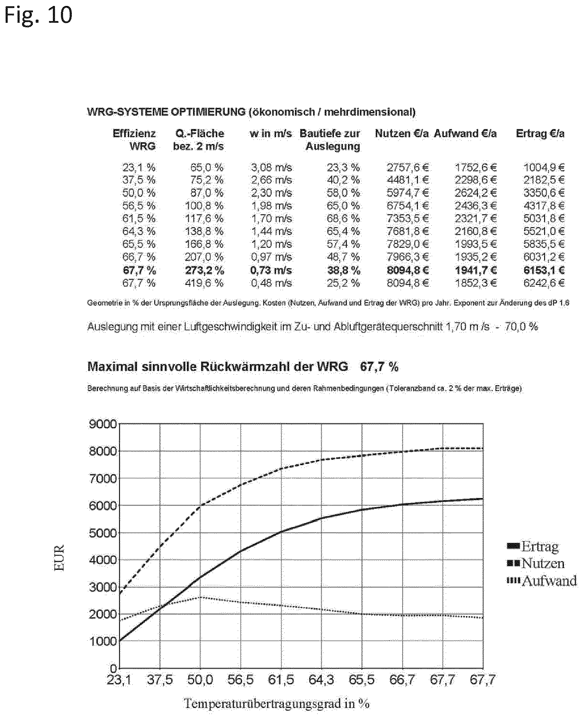

Figur 10: Das mehrdimensionale monetäre Maximum der WRG

Hieraus ergeben sich eine Vielzahl von Optima, die den jeweiligen Flächen und den daraus resultierenden Luftgeschwindigkeiten, bzw. Anströmflächen zugeordnet sind. Aus dieser Vielzahl von Optima kann durch eine Maximalwertbetrachtung das größte Optimum (Maximum der Einsparung oder maximaler Ertrag) bestimmt werden.

Alternativ kann bei einer möglichen räumlichen (geometrischen) Beschränkung das maximal mögliche Optimum bestimmt werden.

Figur 10 stellt das Ergebnis der relationalen mehrdimensionalen Optimierungsrechnung dar. Tatsächlich ergibt sich aus der Berechnung kein Optimum im klassischen Sinne, sondern eine Maximalwertberechnung. Aus den Ergebnissen wird deutlich, dass es nicht als sinnvoll erscheint den Übertragungsgrad der WRG deutlich über 67,7 % zu steigern, da der Ertrag asymptotisch auf ein Maximum zuläuft.

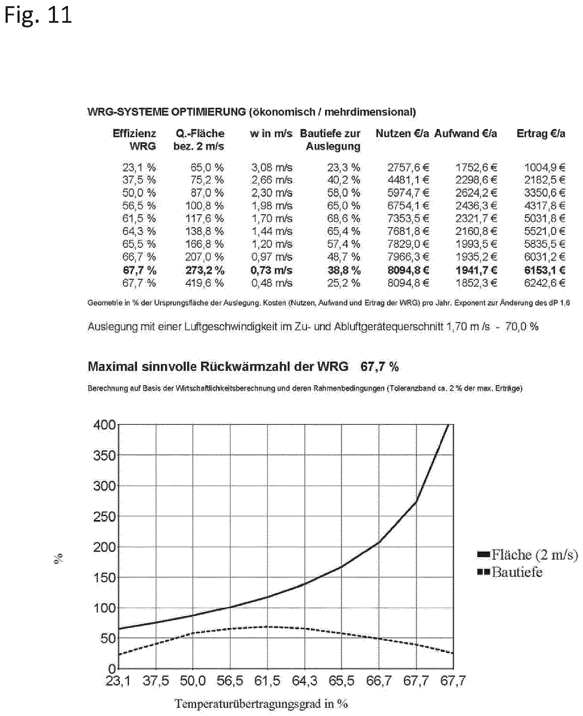

Figur 11: Anströmfläche und Bautiefe der WRG zum Übertragungsgrad

im Beispiel würde dieser maximal sinnvolle Übertragungsgrad bei 67,7 % liegen, wenn unterstellt wird, dass 2 % des theoretisch maximal möglichen Ertrages vernachlässigt werden können. Diese Annahme ist begründbar, da die Fehler zur Berechnung der geänderten k-Zahl schon in einem ähnlich großen Bereich (3 %) liegen. Denn gerade bei geringen Geschwindigkeiten ist die Vorhersage der tatsächlichen Wärmeübertragungsvorgänge besonders schwierig. Es wird auch ersichtlich, dass mit noch kleineren Luftgeschwindigkeiten unter 0,73 m/s der sinnvolle Übertragungsgrad nicht weiter steigt und im Beispiel bei max. 67,7 % verharrt.

Dabei ergeben sich folgende Wärmeübertragergeometrien (siehe Figur 11).

Im vorliegenden Beispiel würde der sinnvolle Übertragungsgrad mit einem Querschnitt von 273 %, also 0,73 m/s bei einer Bautiefe von 38 % zur ursprünglichen Auslegung erreicht werden. Der Ertrag dieser mehrdimensionalen Optimierungsrechnung würde dann auf 6.153 €/a gegenüber der ursprünglichen Auslegung mit 4.932 €/a (+25 %) steigen.

Selbst wenn die Luftgeschwindigkeit deutlich unter 1 m/s in der Auslegung nicht möglich wäre, würde der Ertrag immer noch bei rund 6.030 €/a liegen, während der Wärmeübertrager noch rund 50 % seiner ursprünglichen Bautiefe aufweisen würde.

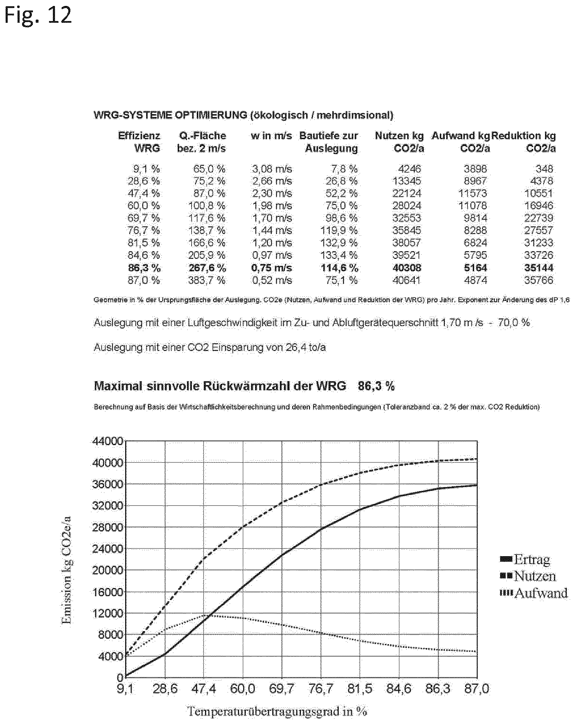

Figur 12: Das mehrdimensionale ökologische Maximum der Wärmerückgewinnung

im Zuge dieser Entwicklung ist mithin herausgearbeitet, dass es auch aus ökonomischer Sicht sinnvoll sein sollte, die WRG mit niedrigen Luftgeschwindigkeiten zu betreiben, da damit einerseits der Übertragungsgrad steigt und andererseits der elektrische Aufwand bedeutend sinkt. Diese Auslegungsalternative führt im Beispiel zu einem 25 % größeren Ertrag trotz großem Querschnitt und den damit verbundenen höheren Investitionskosten.

Selbstverständlich lässt sich auch die mehrdimensionale relationale Optimierungsrechnung nicht nur monetär, sondern auch auf Basis von $CO_2$ Äquivalenten durchführen (siehe Figur 12).

In diesem Fall könnte ebenfalls bei einer Luftgeschwindigkeit von rund 0,75 m/s eine $CO_2$ Reduktion von 35.144 kg/a erreicht werden. Hier allerdings mit einer Bautiefe der WRG von ca. 115 % zur ursprünglichen Auslegung und damit mit einer fast dreimal größeren Bautiefe, als dies unter monetären Gesichtspunkten sinnvoll wäre. Damit könnte die $CO_2$ Einsparung von ursprünglich 26.823 kg/a deutlich erhöht werden (+31 %).

Auch beim Einsatz der mehrdimensionalen Optimierung wird die Schwierigkeit ersichtlich, dass letztlich die Entscheidung für eine der beiden Ausgangspunkte zu treffen ist, da das monetäre Optimum nicht mit dem ökologischen Optimum gleichzusetzen ist.

## Änderung der Rahmenbedingungen

Wie bereits beschrieben gilt die relationale Optimierung der WRG nur für klar definierte Rahmenbedingungen. Ändern sich diese, verschieben sich die Optima deutlich.

Wie beispielsweise im o. g. Berechnungsbeispiel die Laufzeit der Anlage von 4.697 h/a auf 8.760 h/a (7 Tage pro Woche mit 24 h/Tag, nachts abgesenkter Betrieb mit 50 % der Nennluftmenge), so ergeben sich folgende Ergebnisse: Die WRG wird in 7.209 h/a zur Deckung des Wärmebedarfs und in 1.068 h/a zur Kühlung herangezogen. Die Amortisationsdauer verkürzt sich von 3,2 Jahren auf 1,7 Jahre. Der Kapitalwert der Ersparnisse verdoppelt sich etwa von 68.750 € auf 145.260 €.

Das eindimensionale, ökonomische Optimum steigt von 63 % auf 69 %. In diesem Fall wäre die zweite Stufe der Ökodesign-Verordnung auch betriebswirtschaftlich sinnvoll erreichbar (siehe Optimierung von Wärmerückgewinnungssystemen im Kontext volks- und betriebswirtschaftlicher Rahmenbedingungen (Teil 1 und 2), Huss Medien, Moderne Gebäudetechnik, 11 und 12/2016).

Das mehrdimensionale monetäre Maximum würde sich von 67,7 % auf 75 % verschieben. Mit diesem mehrdimensionalen Maximum würde in diesem Beispiel der Ertrag von 10.232 €/a auf 12.373 €/a erhöht werden. Im ersten Beispiel mit geringerer Laufzeit lagen die Erträge bei 4.932 €/a (eindimensional) und 6.153 €/a (mehrdimensional). Die sinnvolle Luftgeschwindigkeit würde bei rund 1,1 m/s liegen.

Das ökologische Optimum basierend auf $CO_2$ Äquivalenten würde sich von 75 % auf 77 % verschieben. Dies erscheint auf den ersten Blick als geringe relative Veränderung, aber absolut gesehen verdoppelt sich bedingt durch die längere Laufzeit die $CO_2$ Einsparung nahezu von 26.823 kg/a auf 50.937 kg/a. Das mehrdimensionale ökologische Maximum verschiebt sich von 86,3 % auf 89,5 %. Absolut werden statt 35.144 kg/a nun 68.072 kg/a $CO_2$ Emissionen eingespart. In diesem Fall läge die sinnvolle Luftgeschwindigkeit bei rund 0,75 m/s.

## Fazit

Wärmerückgewinnung ist eine wichtige Effizienzmaßnahme in der Gebäudetechnik. Es ist grundsätzlich positiv zu bewerten, dass die Ökodesignverordnung einen Rahmen für die verpflichtende Nutzung dieser Technologie geschaffen hat. Das belegen auch die begleitenden Studien, welche die WRG grundsätzlich als eine sehr wirtschaftliche Maßnahme im volkswirtschaftlichen Kontext bestätigt haben.

Zusammenfassend ist die WRG auch unter betriebswirtschaftlichen Gesichtspunkten sehr positiv zu bewerten. Im Einzelfall können sich aber auch negative Ergebnisse zeigen, auch wenn statistisch gesehen die Summe der Einzelfälle volkswirtschaftlich immer noch zu einem positiven Ergebnis führt.

Da im Einzelfall aufgrund der verschiedenen Rahmenbedingungen die Ergebnisse sehr stark variieren und auch zu negativen Ergebnissen führen können, stellt sich zwingend die Frage, ob es nicht sinnvoller wäre, auf Basis von individuellen Rahmenbedingungen ein betriebswirtschaftliches Optimum oder Maximum in jedem Einzelfall zu fordern, anstatt pauschalen Festlegungen den Vorzug zu geben, da sich aufgrund der unterschiedlichen Rahmenbedingungen die Optima deutlich verschieben.

Weiter wird deutlich, dass sowohl zur Erreichung der Referenzwerte der Ökodesign Verordnung für Lüftungsgeräte, als auch zur Erreichung des maximalen Ertrags der WRG die Auslegungsluftgeschwindigkeiten signifikant sinken müssen (unter 1 m/s), um sowohl den thermischen Übertragungsgrad, als auch den SFP-Wert einhalten und den maximalen Ertrag erreichen zu können.

Denn letztlich soll eine gesetzliche Maßnahme die Amortisation und den Kapitalwert der Ersparnisse, also letztlich der maximale Ertrag im Einzelfall ermöglichen.

Die mehrdimensionale Optimierung auf Basis einer relationalen Berechnungsmethodik kann hier leicht aufzeigen, welche sinnvollen Möglichkeiten sich ergeben können.

Es wird ersichtlich, dass dabei ein ökonomisches, wie auch ein ökologischen Optimum oder Maximum erreichbar sind. Beide sind aber wie zu erwarten meist nicht identisch, so dass entscheiden werden muss, ob der ökonomischen oder ökologischen Optimierung oder Maximierung gefolgt werden soll.

Dabei spielt es eine große Rolle, ob die Bewertung letztendlich monetär in Euro und Cent oder ob die Berechnung

auf Basis einer $CO_2$ Einsparung in kg/a erfolgt.

Es ergibt sich in beiden Fällen unter projektspezifischen Rahmenbedingungen ein jeweils eindeutiges Optimum oder Maximum beim Einsatz von WRS.

Somit kann die Festlegung einer optimalen WRG in jedem Fall verhindern, dass mit einer zu kleinen oder einer zu großen WRG ein ökonomisches oder ökologisches Potenzial verschenkt wird. Dies ist sowohl unter betriebswirtschaftlichen als auch unter volkswirtschaftlichen Gesichtspunkten sinnvoll, da die Summe der betriebswirtschaftlichen Optima zu einem volkswirtschaftlichen Optimum führen muss.

Allerdings ruht der Fokus der Betrachtungen immer häufiger auf dem Ziel einer $CO_2$ Einsparung.

Ergänzend zur obigen wissenschaftlichen Beschreibung der Entwicklung ist nachfolgend eine Erläuterung anhand dreier Figuren gegeben.

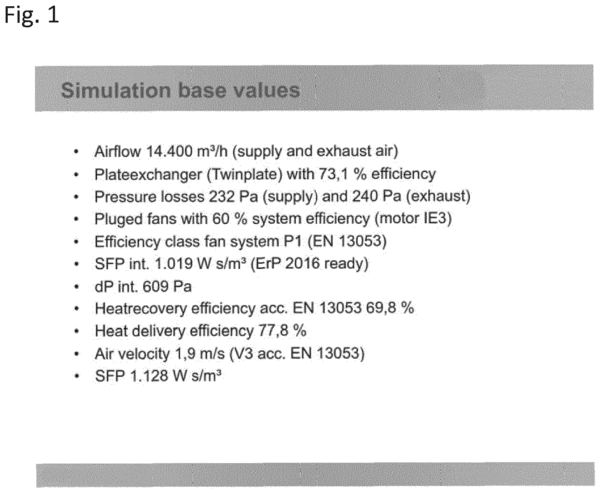

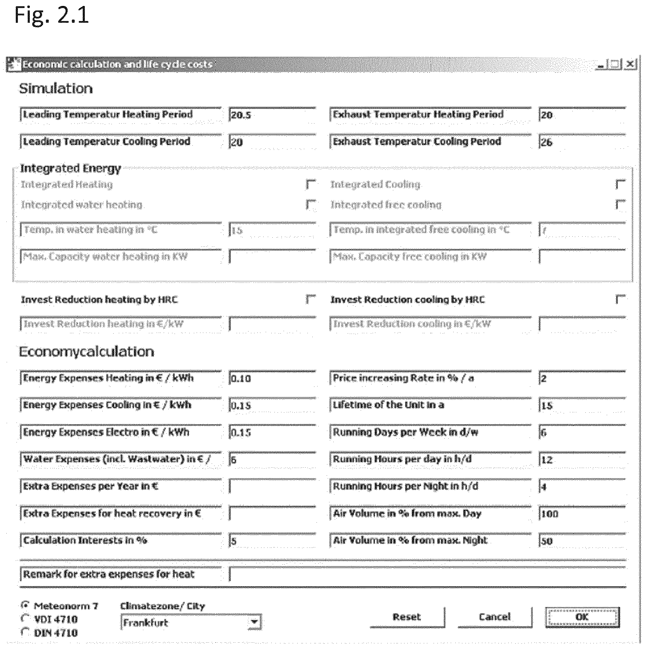

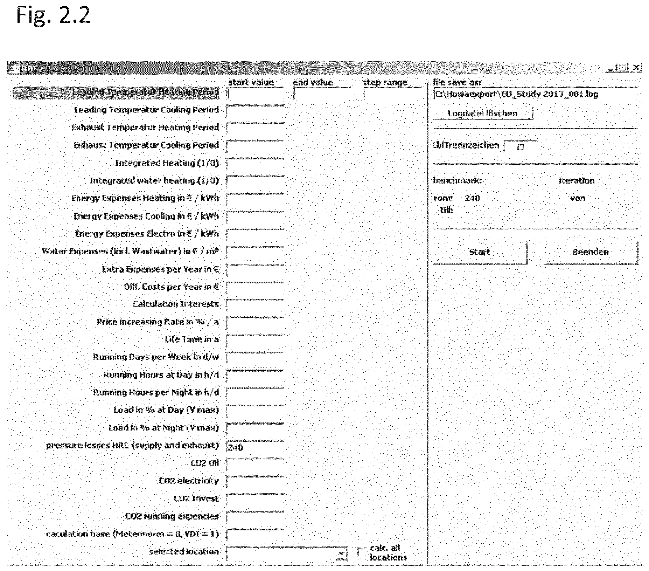

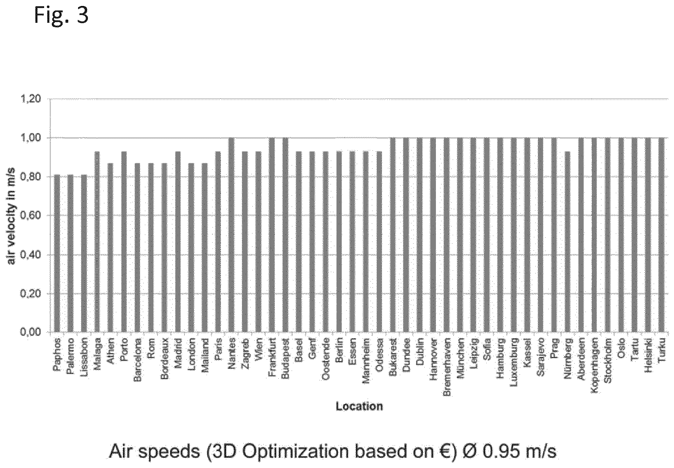

Den Figuren 1 bis 3 ist zu entnehmen, von welchen Basiswerten eine Simulation nach einem bevorzugten Ausführungsbeispiel ausgehen kann. Figur 2 zeigt eine Eingabemaske eines erfindungsgemäßen Optimierungsprogramms zur Eingabe von wirtschaftlichen Rahmenparametern oder Annahmen. In Figur 3 ist beispielhaft eine Ergebnisausgabe gezeigt, wie sie aus einem erfindungsgemäßen Computerprogramm entnommen werden kann. Hier wird ein recht erstaunliches Ergebnis der erfindungsgemäßen Optimierung deutlich. Es konnte nämlich dabei für einen üblichen Fall einer gewöhnlichen raumlufttechnischen Anlage in unterschiedlichen Umgebungen mittels des erfindungsgemäßen Optimierungsverfahrens herausgefunden werden, dass Strömungsgeschwindigkeiten etwa unter 1 m/s sehr vorteilhaft einzustellen sind, um wirtschaftlich und ökologisch vorteilhaft Wärme zu übertragen.

**Patentansprüche**

1. Computerimplementiertes relationales Optimierungsverfahren für einen Wärmeübertrager einer raumlufttechnischen Anlage, wobei, ausgehend von einer Startauslegung des Wärmeübertragers auf Basis seiner charakteristischen Daten, beispielsweise Volumenstrom, Ablufttemperatur, Wirkungsgrad der Wärmerückgewinnung, Außenluftkonditionen und Anströmfläche, die in Auslegungsdaten wie Höhe und Breite als tatsächliche Anströmfläche des Wärmeübertragers, Bautiefe des Wärmeübertragers, wärmeübertragende Fläche des Wärmeübertragers, Wärmedurchgangskoeffizient des Wärmeübertragers und/oder Druckabfall an den Medienseiten resultieren, zum Finden eines unter den gegebenen projektspezifischen Rahmenbedingungen diskreten Optimums für die Effizienz, beispielsweise unter Variation einer dimensionslosen Kennzahl mit jeweils korrespondierendem Temperaturänderungsgrad und jeweils Gegenüberstellung des dazu erforderlichen Aufwands zum möglichen Nutzen der Wärmerückgewinnung, die Optimierung durch Variation zumindest zweier Dimensionen des Wärmeübertragers erfolgt, und wobei das relationale Optimierungsverfahren zumindest die Verfahrensschritte aufweist:

   Änderung der Querschnittsfläche des Wärmeübertragers durch Variation der Höhe und/oder Breite des Wärmeübertragers und Bestimmung der damit einhergehenden Wärmeübertragungseigenschaften mittels einer Näherung sowie des sich bei geänderter Querschnittsfläche ergebenden Druckabfalls,
   Änderung der wärmeübertragenden Fläche des Wärmeübertragers durch Variation der Bautiefe des Wärmeübertragers,
   und anschließend Suche eines diskreten betriebswirtschaftlichen und/oder ökologischen Optimums für die Effizienz des Wärmeübertragers unter den gewählten Querschnittsflächen und Einsetzen des optimierten Wärmeübertragers in die raumlufttechnische Anlage,
   wobei in einer ersten Berechnungsschleife der eingangsseitige Querschnitt des Wärmeübertragers und in einer zweiten Berechnungsschleife die Bautiefe des Wärmeübertragers durch Iteration bestimmt werden, wobei in der ersten Berechnungsschleife die Querschnittsfläche des Wärmeübertragers von einem minimalen Startwert bis zu einem maximal zu wählenden Endwert in festzulegender Schrittweite variiert wird, wobei für jeden Einzelwert auf Basis der Startauslegung sich relational ergebende k-Zahlen bestimmt werden, wobei in der zweiten Berechnungsschleife die Bautiefe des gesuchten Wärmeübertragers von einem Bautiefenstartwert bis zu einem Bautiefenendwert in festzulegender Bautiefenschrittweite variiert wird, wobei in der zweiten Iterationsschleife die jeweilige k-Zahl aus der ersten Berechnungsschleife unverändert bleibt, und wobei die k-Zahl der Wärmedurchgangskoeffizient ist.

2. Computerimplementiertes relationales Optimierungsverfahren nach Anspruch 1, **dadurch gekennzeichnet, dass** die Optimierung durch Variation von genau drei Dimensionen des der Optimierung zugrunde gelegten Wärmeübertragers erfolgt, dies unter Berücksichtigung des geplanten geografischen Standorts und/oder der im Einzelfall gegebenen Rahmenbedingungen, beispielsweise Energiepreise, Laufzeiten und Zinssätze der raumlufttechnischen Anlage.

**3.** Computerimplementiertes relationales Optimierungsverfahren nach mindestens einem der vorangehenden Ansprüche, **dadurch gekennzeichnet, dass** für die diskrete Berechnung des Optimums angenommen wird, dass sich Aufwendungen und Erträge der Wärmerückgewinnung entweder proportional zur Fläche (NTU) oder zur Rückwärmzahl verhalten.

**4.** Computerimplementiertes relationales Optimierungsverfahren nach mindestens einem der vorangehenden Ansprüche, **dadurch gekennzeichnet, dass** im Optimum der Auslegung eine Auslegungsluftgeschwindigkeit von etwa 1 m/s zugrunde liegt.

**5.** Computerimplementiertes relationales Optimierungsverfahren nach mindestens einem der vorangehenden Ansprüche, **dadurch gekennzeichnet, dass** eine Datenbank mit oder eine Abfragemaske zur Abfrage von Auslegungsdaten von zumindest einem Wärmeübertrager, eine Berechnungseinheit sowie eine Ausgabeeinheit vorgesehen sind, mit der einem Nutzer Optimierungsergebnisse präsentiert werden.

**Claims**

**1.** Computer-implemented relational optimisation method for a heat exchanger of a ventilation and air-conditioning system, wherein optimisation is performed by varying at least two dimensions of the heat exchanger starting with an initial design of the heat exchanger based on its characteristic data, for example volume flow, exhaust air temperature, efficiency of the heat recovery, outside air conditions, and incident flow area, resulting in design data such as height and width as the actual incident flow area of the heat exchanger, installation depth of the heat exchanger, heat transfer area of the heat exchanger, heat transfer coefficient of the heat exchanger, and/or pressure drop at the medium sides, in order to determine a discrete optimum for efficiency under the present project-specific framework conditions, for example by varying a dimensionless characteristic with a corresponding degree of temperature change from case to case and comparing the effort required for this from case to case to the possible benefit of the heat recovery, and wherein the relational optimisation method comprises at least the method steps of:

changing of the cross-sectional area of the heat exchanger by varying the height and/or the width of the heat exchanger and determining the associated heat transfer characteristics by means of an approximation as well as the pressure drop resulting from the changed cross-sectional area,
changing of the heat transfer area of the heat exchanger by varying the depth of the heat exchanger,
and subsequently searching for a discrete economic and/or ecological optimum for heat exchanger efficiency under the selected cross-sectional areas and inserting the optimised heat exchanger into the ventilation and air-conditioning system,
wherein the input-side cross-section of the heat exchanger is determined in a first calculation loop and the installation depth of the heat exchanger in a second calculation loop by way of iteration, wherein the cross-sectional area of the heat exchanger is varied from a minimum starting value to a maximum final value to be selected in a step width to be specified in the first calculation loop, wherein k-numbers resulting relationally for each individual value are determined based on the initial design, wherein the depth of the desired heat exchanger is varied from an initial depth value to a final depth value in a depth step width to be specified in the second calculation loop, wherein the respective k-number from the first calculation loop remains unchanged in the second iteration loop, and wherein the k-number is the heat transfer coefficient.

**2.** Computer-implemented relational optimisation method in accordance with claim 1, **characterised in that** the optimisation is performed by varying exactly three dimensions of the heat exchanger underlying the optimisation, under consideration of the planned geographical site and/or the framework conditions present from case to case, for example energy prices, operating times, and interest rates for the ventilation and air-conditioning system.

**3.** Computer-implemented relational optimisation method in accordance with at least one of the preceding claims, **characterised in that** it is assumed for the discrete calculation of the optimum that expenses and yields of the heat recovery are either proportional to the area (NTU) or to the heat recovery efficiency.

**4.** Computer-implemented relational optimisation method in accordance with at least one of the preceding claims, **characterised in that** the design is based on a design air velocity of about 1 m/s in the optimum.

**5.** Computer-implemented relational optimisation method in accordance with at least one of the preceding claims, **characterised in that** a database with or a query mask for querying design data of at least one heat exchanger, a calculation unit as well as an output unit are provided with which optimisation results are presented to a user.

**Revendications**

1. Procédé d'optimisation relationnelle implémenté par ordinateur pour un échangeur de chaleur d'un système de ventilation, dans lequel, à partir d'une conception initiale de l'échangeur de chaleur sur la base de ses données caractéristiques, par exemple le débit volumique, la température de l'air évacué, l'efficacité de la récupération de chaleur, les conditions d'air extérieur et la surface d'écoulement, qui sont converties en données de conception telles que la hauteur et la largeur de la surface d'écoulement réelle de l'échangeur de chaleur, la profondeur de l'échangeur de chaleur, la surface de transfert de chaleur de l'échangeur de chaleur, le coefficient de transfert de chaleur de l'échangeur de chaleur et/ou la chute de pression sur les côtés des fluides, afin de trouver un rendement optimal qui soit discret dans les conditions spécifiques au projet données, par exemple, en faisant varier un nombre sans dimension avec le degré correspondant de variation de température et dans chaque cas en comparant l'effort requis à l'utilisation possible de la récupération de chaleur, l'optimisation est réalisée par variation d'au moins deux dimensions de l'échangeur de chaleur, et dans lequel le procédé d'optimisation relationnelle comprend au moins les étapes du procédé :

   Modifier la surface de la section transversale de l'échangeur de chaleur en faisant varier la hauteur et/ou la largeur de l'échangeur de chaleur et en déterminant les propriétés de transfert de chaleur qui en découlent au moyen d'une approximation et de la chute de pression résultant d'une modification de la surface de la section transversale,
   modifier la surface de transmission de chaleur de l'échangeur de chaleur en faisant varier la profondeur de l'échangeur de chaleur,
   puis rechercher un optimum économique et/ou écologique discret pour l'efficacité de l'échangeur de chaleur dans les sections transversales sélectionnées et l'insertion de l'échangeur de chaleur optimisé dans le système de climatisation,
   dans lequel dans une première boucle de calcul la section transversale côté entrée de l'échangeur de chaleur et dans une seconde boucle de calcul la profondeur de construction de l'échangeur de chaleur sont déterminées par itération, dans laquelle dans la première boucle de calcul, la surface transversale de l'échangeur de chaleur varie d'une valeur de départ minimale à une valeur finale maximale à sélectionner par incréments à déterminer, pour chaque valeur individuelle sur la base de la conception de départ, les nombres k résultant de la relation sont déterminés, la profondeur de construction de l'échangeur de chaleur recherchée variant dans la seconde boucle de calcul d'une valeur de départ de profondeur de construction à une valeur finale de profondeur de construction dans les incréments de profondeur de construction définis, dans la seconde boucle d'itération, le nombre k respectif de la première boucle de calcul restant inchangé, et où le nombre k est le coefficient de transfert thermique.

2. Procédé d'optimisation relationnelle implémenté par ordinateur selon la revendication 1, **caractérisé en ce que** l'optimisation est réalisée par variation de trois dimensions exactement de l'échangeur de chaleur utilisé pour l'optimisation, en tenant compte de la localisation géographique prévue et/ou des conditions données dans des cas individuels, par exemple les prix de l'énergie, les durées de fonctionnement et les taux d'intérêt du système de climatisation.

3. Procédé d'optimisation relationnelle implémenté par ordinateur selon au moins l'une des revendications précédentes, **caractérisé en ce que** pour le calcul discret de l'optimum, on suppose que les efforts et les rendements de la récupération de chaleur sont proportionnels à la surface (NTU) ou au nombre de récupération de chaleur.

4. Procédé d'optimisation relationnelle implémenté par ordinateur selon au moins l'une des revendications précédentes, **caractérisé en ce que** la conception optimale est basée sur une vitesse de l'air de conception d'environ 1 m/s.

5. Procédé d'optimisation relationnelle implémenté par ordinateur selon au moins l'une des revendications précédentes, **caractérisé en ce qu'** il est prévu une base de données avec ou un masque d'interrogation pour interroger des données de conception d'au moins un échangeur de chaleur, une unité de calcul et une unité de sortie avec lesquelles des résultats d'optimisation sont présentés à un utilisateur.

Fig. 1

## Simulation base values

- Airflow 14.400 m³/h (supply and exhaust air)
- Plateexchanger (Twinplate) with 73,1 % efficiency
- Pressure losses 232 Pa (supply) and 240 Pa (exhaust)
- Pluged fans with 60 % system efficiency (motor IE3)
- Efficiency class fan system P1 (EN 13053)
- SFP int. 1.019 W s/m³ (ErP 2016 ready)
- dP int. 609 Pa
- Heatrecovery efficiency acc. EN 13053 69,8 %
- Heat delivery efficiency 77,8 %
- Air velocity 1,9 m/s (V3 acc. EN 13053)
- SFP 1.128 W s/m³

Fig. 2.1

Fig. 2.2

Fig. 3

Air speeds (3D Optimization based on €) Ø 0.95 m/s

Fig. 4

| AL | RL | ETA | WRG | ZL | dT | Q WRG | Q zus. | Q ext. | Status |
|---|---|---|---|---|---|---|---|---|---|
| °C | °C | % | °C | °C | °C | kW | kW | kW | |
| -11,5 | 20,0 | 63,5 | 8,5 | 22,0 | 20,0 | 68,9 | 46,5 | 0,0 | V |
| -10,5 | 20,0 | 65,6 | 9,5 | 22,0 | 20,0 | 68,9 | 43,1 | 0,0 | V |
| -9,5 | 20,0 | 67,8 | 10,5 | 22,0 | 20,0 | 68,9 | 39,6 | 0,0 | V |
| -8,5 | 20,0 | 70,0 | 11,5 | 22,0 | 20,0 | 68,7 | 36,3 | 0,0 | |
| -7,5 | 20,0 | 70,0 | 11,8 | 22,0 | 19,3 | 66,3 | 35,3 | 0,0 | |
| -6,5 | 20,0 | 70,0 | 12,0 | 22,0 | 18,5 | 63,9 | 34,3 | 0,0 | |
| -5,5 | 20,0 | 70,0 | 12,3 | 22,0 | 17,8 | 61,5 | 33,2 | 0,0 | |
| -4,5 | 20,0 | 70,0 | 12,6 | 22,0 | 17,2 | 59,1 | 32,2 | 0,0 | |
| -3,5 | 20,0 | 70,0 | 13,0 | 22,0 | 16,5 | 56,7 | 31,2 | 0,0 | |
| -2,5 | 20,0 | 70,0 | 13,2 | 22,0 | 15,7 | 54,3 | 30,1 | 0,0 | |
| -1,5 | 20,0 | 70,0 | 13,6 | 22,0 | 15,1 | 51,9 | 29,1 | 0,0 | |
| -0,5 | 20,0 | 70,0 | 13,9 | 22,0 | 14,4 | 49,4 | 28,1 | 0,0 | |
| 0,5 | 20,0 | 70,0 | 14,2 | 22,0 | 13,7 | 47,0 | 27,0 | 0,0 | |
| 1,5 | 20,0 | 70,0 | 14,5 | 22,0 | 13,0 | 44,6 | 26,0 | 0,0 | |
| 2,5 | 20,0 | 70,0 | 14,8 | 22,0 | 12,3 | 42,2 | 25,0 | 0,0 | |
| 3,5 | 20,0 | 70,0 | 15,1 | 22,0 | 11,5 | 39,8 | 23,9 | 0,0 | |
| 4,5 | 20,0 | 70,0 | 15,4 | 22,0 | 10,9 | 37,4 | 22,9 | 0,0 | |
| 5,5 | 20,0 | 70,0 | 15,7 | 22,0 | 10,1 | 35,0 | 21,9 | 0,0 | |
| 6,5 | 20,0 | 70,0 | 16,0 | 22,0 | 9,5 | 32,6 | 20,8 | 0,0 | |
| 7,5 | 20,0 | 70,0 | 16,3 | 22,0 | 8,8 | 30,1 | 19,8 | 0,0 | |
| 8,5 | 20,0 | 70,0 | 16,5 | 22,0 | 8,0 | 27,7 | 18,8 | 0,0 | |
| 9,5 | 20,0 | 70,0 | 16,9 | 22,0 | 7,4 | 25,3 | 17,7 | 0,0 | |
| 10,5 | 20,0 | 70,0 | 17,2 | 22,0 | 6,6 | 22,9 | 16,7 | 0,0 | |
| 11,5 | 20,0 | 70,0 | 17,5 | 22,0 | 5,9 | 20,5 | 15,7 | 0,0 | |
| 12,5 | 20,0 | 70,0 | 17,8 | 22,0 | 5,3 | 18,1 | 14,6 | 0,0 | |
| 13,5 | 20,0 | 70,0 | 18,1 | 22,0 | 4,6 | 15,7 | 13,6 | 0,0 | |
| 14,5 | 20,0 | 70,0 | 18,4 | 22,0 | 3,9 | 13,3 | 12,6 | 0,0 | |
| 15,5 | 20,0 | 70,0 | 18,7 | 22,0 | 3,1 | 10,9 | 11,5 | 0,0 | |
| 16,5 | 20,0 | 70,0 | 19,0 | 22,0 | 2,4 | 8,4 | 10,5 | 0,0 | |
| 17,5 | 20,0 | 70,0 | 19,3 | 22,0 | 1,8 | 6,0 | 9,5 | 0,0 | |
| 18,5 | 20,0 | 70,0 | 19,6 | 22,0 | 1,1 | 3,6 | 8,4 | 0,0 | |
| 19,5 | 19,5 | 0,0 | 19,5 | 19,5 | 0,0 | 0,0 | 0,0 | 0,0 | AUS |
| 20,5 | 20,5 | 0,0 | 20,5 | 20,5 | 0,0 | 0,0 | 0,0 | 0,0 | AUS |
| 21,5 | 17,6 | 70,0 | 18,8 | 18,0 | -2,7 | -9,4 | -2,7 | 0,0 | S 2 |
| 22,5 | 17,6 | 70,0 | 19,1 | 18,0 | -3,4 | -11,8 | -3,7 | 0,0 | S 2 |
| 23,5 | 17,6 | 70,0 | 19,4 | 18,0 | -4,1 | -14,2 | -4,7 | 0,0 | S 2 |
| 24,5 | 17,6 | 70,0 | 19,7 | 18,0 | -4,8 | -16,6 | -5,8 | 0,0 | S 2 |
| 25,5 | 17,6 | 70,0 | 20,0 | 18,0 | -5,5 | -19,1 | -6,8 | 0,0 | S 2 |
| 26,5 | 17,6 | 70,0 | 20,3 | 18,0 | -6,2 | -21,5 | -7,8 | 0,0 | S 2 |
| 27,5 | 17,6 | 70,0 | 20,6 | 18,0 | -6,9 | -23,9 | -8,9 | 0,0 | S 2 |
| 28,5 | 17,6 | 70,0 | 20,9 | 18,0 | -7,6 | -26,3 | -9,9 | 0,0 | S 2 |
| 29,5 | 17,6 | 70,0 | 21,2 | 18,0 | -8,3 | -28,7 | -10,9 | 0,0 | S 2 |
| 30,5 | 17,6 | 70,0 | 21,5 | 18,0 | -9,0 | -31,1 | -12,0 | 0,0 | S 2 |
| 31,5 | 17,6 | 70,0 | 21,8 | 18,0 | -9,7 | -33,5 | -13,0 | 0,0 | S 2 |
| 32,5 | 17,6 | 70,0 | 22,1 | 18,0 | -10,4 | -35,9 | -14,0 | 0,0 | S 2 |

V = Eisschutz / E = Nachheizen / K = Nachkühlen / S = Stufe(n) / F = frei Kälte / B = Brauchwasser
L = Leistungsanpassung / AL = Aussenlufttemp. / RL = Raumlufttemp. (nach Bef.) / ZL = Zulufttemp.
Simulation unter konstanten Bedingungen nur trocken !

# Fig. 5

| °C | kW | Tag h/°C | Nacht h/°C | Gesamt kWh | Gesamt kWh | WRG kWh | WRG kWh | Kälte kWh | wasser kWh | m³ |
|---|---|---|---|---|---|---|---|---|---|---|
| < -10,5 | 68,9 | 4 | 3 | 659 | | 429 | | | | |
| -10,5 | 68,9 | 3 | 2 | 411 | | 277 | | | | |
| -9,5 | 68,9 | 4 | 3 | 531 | | 369 | | | | |
| -8,5 | 68,7 | 5 | 4 | 663 | | 474 | | | | |
| -7,5 | 66,3 | 6 | 5 | 864 | | 617 | | | | |
| -6,5 | 63,9 | 8 | 7 | 1.121 | | 799 | | | | |
| -5,5 | 61,5 | 12 | 10 | 1.578 | | 1.123 | | | | |
| -4,5 | 59,1 | 17 | 13 | 2.123 | | 1.505 | | | | |
| -3,5 | 56,7 | 25 | 20 | 3.113 | | 2.199 | | | | |
| -2,5 | 54,3 | 35 | 28 | 4.169 | | 2.937 | | | | |
| -1,5 | 51,9 | 47 | 38 | 5.333 | | 3.742 | | | | |
| -0,5 | 49,4 | 53 | 42 | 5.735 | | 4.004 | | | | |
| 0,5 | 47,0 | 75 | 60 | 7.731 | | 5.371 | | | | |
| 1,5 | 44,6 | 81 | 65 | 8.041 | | 5.563 | | | | |
| 2,5 | 42,2 | 86 | 69 | 8.126 | | 5.589 | | | | |
| 3,5 | 39,8 | 93 | 75 | 8.323 | | 5.696 | | | | |
| 4,5 | 37,4 | 96 | 77 | 8.094 | | 5.498 | | | | |
| 5,5 | 35,0 | 106 | 85 | 8.405 | | 5.672 | | | | |
| 6,5 | 32,6 | 109 | 87 | 8.157 | | 5.454 | | | | |
| 7,5 | 30,1 | 115 | 92 | 8.033 | | 5.297 | | | | |
| 8,5 | 27,7 | 113 | 90 | 7.330 | | 4.782 | | | | |
| 9,5 | 25,3 | 114 | 91 | 6.878 | | 4.422 | | | | |
| 10,5 | 22,9 | 111 | 88 | 6.131 | | 3.883 | | | | |
| 11,5 | 20,5 | 113 | 90 | 5.720 | | 3.547 | | | | |
| 12,5 | 18,1 | 112 | 90 | 5.131 | | 3.111 | | | | |
| 13,5 | 15,7 | 110 | 88 | 4.492 | | 2.636 | | | | |
| 14,5 | 13,3 | 107 | 86 | 3.863 | | 2.181 | | | | |
| 15,5 | 10,9 | 106 | 85 | 3.328 | | 1.774 | | | | |
| 16,5 | 8,4 | 101 | 81 | 2.670 | | 1.300 | | | | |
| 17,5 | 6,0 | 94 | 75 | 2.040 | | 865 | | | | |
| 18,5 | 3,6 | 87 | 70 | 1.477 | | 481 | | | | |
| 19,5 | 0,0 | 78 | 62 | | | | | | | |
| 20,5 | 0,0 | 68 | 54 | | | | | | | |
| 21,5 | -9,4 | 59 | 47 | | 994 | | 846 | | | 6 |
| 22,5 | -11,8 | 48 | 39 | | 1.051 | | 877 | | | 5 |
| 23,5 | -14,2 | 42 | 34 | | 1.110 | | 913 | | | 4 |
| 24,5 | -16,6 | 36 | 29 | | 1.142 | | 927 | | | 4 |
| 25,5 | -19,1 | 30 | 24 | | 1.077 | | 873 | | | 3 |
| 26,5 | -21,5 | 24 | 19 | | 989 | | 795 | | | 2 |
| 27,5 | -23,9 | 21 | 17 | | 984 | | 787 | | | 2 |
| 28,5 | -26,3 | 18 | 14 | | 890 | | 708 | | | 2 |
| 29,5 | -28,7 | 13 | 10 | | 728 | | 578 | | | 1 |
| 30,5 | -31,1 | 11 | 8 | | 636 | | 502 | | | 1 |
| 31,5 | -33,5 | 6 | 5 | | 406 | | 320 | | | 1 |
| > 31,5 | -35,9 | 10 | 8 | | 679 | | 533 | | | 1 |
| Gesamt Jahr | VDI 4710 12-Mann heim | 2.610 | 2.087 | 140.254 3.862 h | 10.678 572 h | 91.580 | 8.652 | | | 32 |

# Fig. 6

| | |
|---|---|
| Energiekosten Wärme | 0,080 € / kWh |
| Energiekosten Kälte | 0,120 € / kWh |
| Energiekosten Elektro | 0,150 € / kWh |
| Wasserkosten (inkl. Abwasser) | 10,00 € / m³ |
| Kalkulationszinsfuß | 3,00 % |
| Preissteigerungsrate | 2,00 % |
| Klimazone/ Standort | 12-Mannheim |
| Nutzungsdauer der Anlage | 15 a |
| Betriebstage pro Woche | 5 d / w |
| Betriebsstunden pro Tag | 10 h / d |
| Betriebsstunden pro Nacht | 8 h / d |
| Volumenstrom am Tag | 100 % / V max |
| Volumenstrom in der Nacht | 50 % / V max |
| Investitionskosten der WRG | 30.576 € |
| Mehr-/Minderinvestition für die WRG | 0 € |
| Min.investition für Wärmeerzeugung | 0 € / (0 € / kW) |
| Min.investition für Kälteerzeugung | -10.626 € / (296 € / kW) |
| Zusatzkosten je Jahr | 0 € |
| Rückgewinn der WRG Wärme | 7.326 € / a |
| Rückgewinn der WRG Kälte | 1.038 € / a |
| Elektroenergiekosten für die WRG | 1.260 € / a |
| Wasserkosten (indirekte Verdunstungskühlung) | 318 € / a |
| Kapitalkosten für die WRG | 1.671 € / a |
| Wartungs- und Unterhaltungskosten | 399 € / a |
| Jährliche Differenzkosten | 4.717 € / a |
| Kapitalwert der Ersparnisse | 68.751 € |
| Kalkulationszinsfuß | 34,2 % |
| Amortisation | 3,2 a |
| Jahresnutzungsgrad (bezogen auf Energien) | 66,4 % |
| Jahresarbeitszahl nach EN 13053 | 11,9 |
| Leistungszahl nach EN 13053 | 16,4 |
| Effektiver Jahreswirkungsgrad EN 13053 | 65,7 % |

Wärmerückgewinnung 66,4%
Primärenergie 33,6%

Einnahmen
Ausgaben

# Fig. 7

**WRG-SYSTEME OPTIMIERUNG (ökonomisch / WRG Fläche konstant)**

| Effizienz WRG | Bautiefe zur Auslegung | Nutzen €/a | Aufwand €/a | Ertrag €/a |
|---|---|---|---|---|
| 30,0 % | 18,4 % | 3584,8 € | 711,7 € | 2873,1 € |
| 35,0 % | 23,1 % | 4182,3 € | 846,9 € | 3335,4 € |
| 40,0 % | 28,6 % | 4779,8 € | 1015,2 € | 3764,6 € |
| 45,0 % | 35,1 % | 5377,3 € | 1225,6 € | 4151,6 € |
| 50,0 % | 42,9 % | 5974,7 € | 1490,9 € | 4483,9 € |
| 55,0 % | 52,4 % | 6572,2 € | 1829,2 € | 4743,0 € |
| 60,0 % | 64,3 % | 7169,7 € | 2268,0 € | 4901,7 € |
| **63,0 %** | **73,0 %** | **7528,2 €** | **2596,5 €** | **4931,7 €** |
| 65,0 % | 79,6 % | 7767,2 € | 2850,4 € | 4916,8 € |
| 70,0 % | 100,0 % | 8364,6 € | 3648,0 € | 4716,6 € |

Kosten (Nutzen, Aufwand und Ertrag der WRG) pro Jahr

Auslegung mit einer Luftgeschwindigkeit im Zu- und Abluftgerätequerschnitt 1,70 m /s - 70,0 %

**Optimale Rückwärmzahl der WRG**     **63 %   ( 60 - 66 % )**

Berechnung auf Basis der Wirtschaftlichkeitsberechnung und deren Rahmenbedingungen (Toleranzband ± 1 % der Kosten)

# Fig. 8

**WRG-SYSTEME OPTIMIERUNG (ökologisch / WRG Fläche konstant)**

| Effizienz WRG | Bautiefe zur Auslegung | Nutzen kg CO2/a | Aufwand kg CO2/a | Reduktion kg CO2/a |
|---|---|---|---|---|
| 30,0 % | 18,4 % | 14012 | 1025 | 12987 |
| 35,0 % | 23,1 % | 16347 | 1309 | 15039 |
| 40,0 % | 28,6 % | 18683 | 1646 | 17037 |
| 45,0 % | 35,1 % | 21018 | 2051 | 18967 |
| 50,0 % | 42,9 % | 23353 | 2545 | 20809 |
| 55,0 % | 52,4 % | 25689 | 3157 | 22532 |
| 60,0 % | 64,3 % | 28024 | 3932 | 24092 |
| 65,0 % | 79,6 % | 30359 | 4938 | 25421 |
| 70,0 % | 100,0 % | 32695 | 6294 | 26401 |
| **75,0 %** | **128,6 %** | **35030** | **8206** | **26823** |
| 80,0 % | 171,4 % | 37365 | 11095 | 26271 |
| 85,0 % | 242,9 % | 39701 | 15933 | 23767 |

CO2-Emissionen (Einsparung, Aufwand und Nettoertrag der WRG)

CO2e-Äquivalente pro Jahr berechnet mit 340 g/kWh Wärme, 630 g/kWh Strom, sowie 600 g/€ WRG Invest und sonstige Betriebskosten 600 g/€

Auslegung mit einer Luftgeschwindigkeit im Zu- und Abluftgerätequerschnitt 1,70 m /s - 70,0 %

Auslegung mit einer CO2 Einsparung von 26,4 to/a

**Optimale Rückwärmzahl der WRG**      **75 % ( 72 - 78 % )**

Berechnung auf Basis der Wirtschaftlichkeitsberechnung und deren Rahmenbedingungen (Toleranzband ± 1 % der CO2-Emissionen)

Ertrag — Nutzen — Aufwand

Emission kg CO2e/a — Temperaturübertragungsgrad in %

# Fig. 9

**WRG-SYSTEME OPTIMIERUNG (ökonomisch / WRG Bautiefe konstant)**

| Effizienz WRG | Q.-Fläche bez. 2 m/s | w in m/s | Nutzen €/a | Aufwand €/a | Ertrag €/a |
|---|---|---|---|---|---|
| 59,9 % | 75,2 % | 2,66 m/s | 7153,0 € | 5141,8 € | 2011,2 € |
| 63,3 % | 87,0 % | 2,30 m/s | 7564,2 € | 4179,7 € | 3384,5 € |
| 66,7 % | 100,8 % | 1,98 m/s | 7966,3 € | 3707,4 € | 4259,0 € |
| 70,0 % | 117,6 % | 1,70 m/s | 8364,6 € | 3648,0 € | 4716,6 € |
| **72,0 %** | **129,7 %** | **1,54 m/s** | **8604,3 €** | **3810,5 €** | **4793,8 €** |
| 73,4 % | 138,8 % | 1,44 m/s | 8765,2 € | 4011,2 € | 4754,1 € |
| 76,8 % | 166,8 % | 1,20 m/s | 9176,1 € | 4924,5 € | 4251,6 € |
| 80,4 % | 207,0 % | 0,97 m/s | 9609,4 € | 6774,5 € | 2834,9 € |

Geometrie in % der Ursprungsfläche der Auslegung. Kosten (Nutzen, Aufwand und Ertrag der WRG) pro Jahr. Exponent zur Änderung des dP 1,6

Auslegung mit einer Luftgeschwindigkeit im Zu- und Abluftgerätequerschnitt 1,70 m /s  -  70,0 %

**Optimale Rückwärmzahl der WRG**          **72,0 %   ( 70,7 - 73,4 % )**

Berechnung auf Basis der Wirtschaftlichkeitsberechnung und deren Rahmenbedingungen (Toleranzband ± 1 % der Kosten)

# Fig. 10

**WRG-SYSTEME OPTIMIERUNG (ökonomisch / mehrdimensional)**

| Effizienz WRG | Q.-Fläche bez. 2 m/s | w in m/s | Bautiefe zur Auslegung | Nutzen €/a | Aufwand €/a | Ertrag €/a |
|---|---|---|---|---|---|---|
| 23,1 % | 65,0 % | 3,08 m/s | 23,3 % | 2757,6 € | 1752,6 € | 1004,9 € |
| 37,5 % | 75,2 % | 2,66 m/s | 40,2 % | 4481,1 € | 2298,6 € | 2182,5 € |
| 50,0 % | 87,0 % | 2,30 m/s | 58,0 % | 5974,7 € | 2624,2 € | 3350,6 € |
| 56,5 % | 100,8 % | 1,98 m/s | 65,0 % | 6754,1 € | 2436,3 € | 4317,8 € |
| 61,5 % | 117,6 % | 1,70 m/s | 68,6 % | 7353,5 € | 2321,7 € | 5031,8 € |
| 64,3 % | 138,8 % | 1,44 m/s | 65,4 % | 7681,8 € | 2160,8 € | 5521,0 € |
| 65,5 % | 166,8 % | 1,20 m/s | 57,4 % | 7829,0 € | 1993,5 € | 5835,5 € |
| 66,7 % | 207,0 % | 0,97 m/s | 48,7 % | 7966,3 € | 1935,2 € | 6031,2 € |
| **67,7 %** | **273,2 %** | **0,73 m/s** | **38,8 %** | **8094,8 €** | **1941,7 €** | **6153,1 €** |
| 67,7 % | 419,6 % | 0,48 m/s | 25,2 % | 8094,8 € | 1852,3 € | 6242,6 € |

Geometrie in % der Ursprungsfläche der Auslegung. Kosten (Nutzen, Aufwand und Ertrag der WRG) pro Jahr. Exponent zur Änderung des dP 1,6

Auslegung mit einer Luftgeschwindigkeit im Zu- und Abluftgerätequerschnitt 1,70 m /s  -  70,0 %

**Maximal sinnvolle Rückwärmzahl der WRG   67,7 %**

Berechnung auf Basis der Wirtschaftlichkeitsberechnung und deren Rahmenbedingungen (Toleranzband ca. 2 % der max. Erträge)

# Fig. 11

**WRG-SYSTEME OPTIMIERUNG (ökonomisch / mehrdimensional)**

| Effizienz WRG | Q.-Fläche bez. 2 m/s | w in m/s | Bautiefe zur Auslegung | Nutzen €/a | Aufwand €/a | Ertrag €/a |
|---|---|---|---|---|---|---|
| 23,1 % | 65,0 % | 3,08 m/s | 23,3 % | 2757,6 € | 1752,6 € | 1004,9 € |
| 37,5 % | 75,2 % | 2,66 m/s | 40,2 % | 4481,1 € | 2298,6 € | 2182,5 € |
| 50,0 % | 87,0 % | 2,30 m/s | 58,0 % | 5974,7 € | 2624,2 € | 3350,6 € |
| 56,5 % | 100,8 % | 1,98 m/s | 65,0 % | 6754,1 € | 2436,3 € | 4317,8 € |
| 61,5 % | 117,6 % | 1,70 m/s | 68,6 % | 7353,5 € | 2321,7 € | 5031,8 € |
| 64,3 % | 138,8 % | 1,44 m/s | 65,4 % | 7681,8 € | 2160,8 € | 5521,0 € |
| 65,5 % | 166,8 % | 1,20 m/s | 57,4 % | 7829,0 € | 1993,5 € | 5835,5 € |
| 66,7 % | 207,0 % | 0,97 m/s | 48,7 % | 7966,3 € | 1935,2 € | 6031,2 € |
| **67,7 %** | **273,2 %** | **0,73 m/s** | **38,8 %** | **8094,8 €** | **1941,7 €** | **6153,1 €** |
| 67,7 % | 419,6 % | 0,48 m/s | 25,2 % | 8094,8 € | 1852,3 € | 6242,6 € |

Geometrie in % der Ursprungsfläche der Auslegung. Kosten (Nutzen, Aufwand und Ertrag der WRG) pro Jahr. Exponent zur Änderung des dP 1,6

Auslegung mit einer Luftgeschwindigkeit im Zu- und Abluftgerätequerschnitt 1,70 m /s  -  70,0 %

**Maximal sinnvolle Rückwärmzahl der WRG   67,7 %**

Berechnung auf Basis der Wirtschaftlichkeitsberechnung und deren Rahmenbedingungen (Toleranzband ca. 2 % der max. Erträge)

# Fig. 12

**WRG-SYSTEME OPTIMIERUNG (ökologisch / mehrdimsional)**

| Effizienz WRG | Q.-Fläche bez. 2 m/s | w in m/s | Bautiefe zur Auslegung | Nutzen kg CO2/a | Aufwand kg CO2/a | Reduktion kg CO2/a |
|---|---|---|---|---|---|---|
| 9,1 % | 65,0 % | 3,08 m/s | 7,8 % | 4246 | 3898 | 348 |
| 28,6 % | 75,2 % | 2,66 m/s | 26,8 % | 13345 | 8967 | 4378 |
| 47,4 % | 87,0 % | 2,30 m/s | 52,2 % | 22124 | 11573 | 10551 |
| 60,0 % | 100,8 % | 1,98 m/s | 75,0 % | 28024 | 11078 | 16946 |
| 69,7 % | 117,6 % | 1,70 m/s | 98,6 % | 32553 | 9814 | 22739 |
| 76,7 % | 138,7 % | 1,44 m/s | 119,9 % | 35845 | 8288 | 27557 |
| 81,5 % | 166,6 % | 1,20 m/s | 132,9 % | 38057 | 6824 | 31233 |
| 84,6 % | 205,9 % | 0,97 m/s | 133,4 % | 39521 | 5795 | 33726 |
| **86,3 %** | **267,6 %** | **0,75 m/s** | **114,6 %** | **40308** | **5164** | **35144** |
| 87,0 % | 383,7 % | 0,52 m/s | 75,1 % | 40641 | 4874 | 35766 |

Geometrie in % der Ursprungsfläche der Auslegung. CO2e (Nutzen, Aufwand und Reduktion der WRG) pro Jahr. Exponent zur Änderung des dP 1,6

Auslegung mit einer Luftgeschwindigkeit im Zu- und Abluftgerätequerschnitt 1,70 m /s - 70,0 %

Auslegung mit einer CO2 Einsparung von 26,4 to/a

## Maximal sinnvolle Rückwärmzahl der WRG   86,3 %

Berechnung auf Basis der Wirtschaftlichkeitsberechnung und deren Rahmenbedingungen (Toleranzband ca. 2 % der max. CO2 Reduktion)

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102015016879

- CN 102508958 A

**In der Beschreibung aufgeführte Nicht-Patentliteratur**

- Rationelle Energienutzung in Gebäuden. **H. HUBER.** Luftkanal-Wärmetauscher. Hochschule Technik + Architektur Luzern, September 2000
- Wirtschaftliche Bewertung und Optimierung von Wärmerückgewinnungssystemen. Springer-VDI Verlag

- Optimierung von Wärmerückgewinnungssystemen im Kontext volks- und betriebswirtschaftlicher Rahmenbedingungen. Moderne Gebäudetechnik. Huss Medien, November 2016